# EUROPEAN PATENT SPECIFICATION

(11) **EP 4 411 510 B1**
(45) Date of publication and mention of the grant of the patent: **15.04.2026**
(21) Application number: 23817643.2
(22) Date of filing: 13.12.2023
(51) Int. Cl.: G06F 1/16, H04M 1/02, H05K 1/02, H05K 9/00

(54) **ELECTRONIC DEVICE COMPRISING CONDUCTIVE MEMBER**
ELEKTRONISCHE VORRICHTUNG MIT LEITFÄHIGEM ELEMENT
DISPOSITIF ÉLECTRONIQUE COMPRENANT UN ÉLÉMENT CONDUCTEUR

(30) Priority: 13.12.2022 KR 20220174091; 11.01.2023 KR 20230004331
(43) Date of publication of application: 07.08.2024
(73) Proprietor: Samsung Electronics Co., Ltd., Suwon-si, Gyeonggi-do 16677 (KR)
(72) Inventor: LEE, Daekyu, Suwon-si, Gyeonggi-do 16677 (KR); LEE, Jongwoon, Suwon-si, Gyeonggi-do 16677 (KR); OH, Myeongsu, Suwon-si, Gyeonggi-do 16677 (KR)
(74) Representative: Gulde & Partner
(86) International application number: PCT/KR2023/020573
(87) International publication number: WO 2024/128810

(56) References cited:
- WO-A2-2022/173217
- CN-A- 108 023 978
- CN-A- 114 007 348
- KR-A- 20170 028 278
- KR-A- 20200 018 282
- KR-A- 20220 015 916
- US-A1- 2022 346 241

## Description

### [Technical Field]

Various embodiments relate to an electronic device including a conductive member.

### [Background Art]

With the increase of degree of integration of electronic devices and the generalization of ultra-high-speed and high-capacity wireless communication, recently, a single electronic device, such as a mobile communication terminal, may be provided with various functions. For example, various functions, such as an entertainment function (e.g., a game function), a multimedia function (e.g., music/video playback), a communication and security function for mobile banking or the like, a schedule management function, and an e-wallet function, have come to be integrated in a single electronic device, in addition to a communication function. In addition, electronic devices are increasingly equipped with wider display panels so that users do not have any inconvenience in using multimedia services.

Recently, foldable electronic devices including a flexible display have been disclosed. The term "foldable electronic device" may mean an electronic device that includes a plurality of housings and a foldable display located on or inside the plurality of housings, wherein the plurality of housings rotate relative to each other. US 2022/346241 A1 discloses an electronic device with foldable housing including a first and a second housing and a foldable display. The electronic device includes a support member, a protection member, and a conductive member, wherein the support member comprises a first metal area forming a side surface, a second metal area for support of the display and a resin are therebetween. WO 2022/183217 A2 further discloses another display device with foldable housing including a first and a second housing and foldable display. The electronic device includes a (second) side frame, a (second) protective cover and a conductive member. The (second) side frame may include an insulating segment between a first metal frame and a second metal frame.

The above-described information may be provided as background for the purpose of helping understanding of the disclosure. No claim or determination is made as to whether any of the foregoing may be applied as a prior art in connection with the disclosure.

### [Detailed Description of the Invention]

### [Technical Solution]

According to the invention, an electronic device is provided as claimed in the appended set of claims.

According to an embodiment of the disclosure, an electronic device is provided. The electronic device may include a housing including a first housing and a second housing and configured to be foldable around a folding axis, and a flexible display. The housing may include a protection member having an outer surface facing outside of the electronic device and an inner surface facing at least a portion of the flexible display, wherein the protection member includes a non-conductive portion and a conductive portion disposed on the inner surface, and a side surface member defining a side surface of the housing and including a first portion formed of a conductive material, a second portion formed of a conductive material and electrically separated from the first portion, and a split portion provided between the first portion and the second portion and formed of an insulating material. The conductive portion may include a first conductive portion extending in parallel to a length direction of the electronic device, and a second conductive portion extending from an end of the first conductive portion at a position corresponding to the split portion toward the side surface member.

According to an embodiment of the disclosure, it is possible to provide a foldable electronic device. The foldable electronic device may include a housing including a first housing and a second housing and configured to be foldable about a folding axis, wherein the housing may include a first side surface portion extending in parallel to the folding axis, a second side surface portion extending from a first end of the first side surface portion and perpendicular to the folding axis, a third side surface portion extending from the second end of the first side surface portion and perpendicular to the folding axis, and a fourth side surface portion extending between the second side surface portion and the third side surface portion and parallel to the folding axis; and a flexible display. The housing may include a protection member having an outer surface facing outside of the electronic device and an inner surface facing at least a portion of the flexible display, wherein the protection member includes a non-conductive portion and a conductive portion disposed on the inner surface; and a side surface member defining the first side surface portion, the second side surface portion, the third side surface portion, and the fourth side surface portion of the housing, wherein the side surface member includes a first portion formed of a conductive material, a second portion formed of a conductive material and electrically separated from the first portion, and a split portion formed of an insulating material between the first portion and the second portion. The conductive portion may include a first conductive portion extending along the first side surface portion in parallel to the length direction of the electronic device, and a second conductive portion extending from an end of the first conductive portion at a position corresponding to the split portion toward the side surface member, whereby the conductive portion is capable of discharging static electricity.

According to an embodiment of the disclosure, it is possible to provide an electronic device. The electronic device may include a housing configured to be foldable, and a flexible display. The housing may include a protection member including a non-conductive portion and a conductive portion, and a side surface member defining a side surface of the housing and at least partially formed of a conductive material. The conductive portion may include a first conductive portion disposed on an inner surface of the protection member and extending at least partially in parallel to a length direction of the electronic device, and a second conductive portion connected to the first conductive portion and extending in a direction different from the direction in which the first conductive portion extends.

### [Brief Description of Drawings]

The above-described aspects or other aspects, configurations, and/or advantages regarding an embodiment of the disclosure may become more apparent through the following detailed description made with reference to the accompanying drawings.
FIG. 1 is a view illustrating an unfolded state of an electronic device according to an embodiment of the disclosure.
FIG. 2 is a view illustrating a folded state of the electronic device according to an embodiment of the disclosure.
FIG. 3 is an exploded perspective view of an electronic device according to an embodiment of the disclosure.
FIG. 4 is a cross-sectional view of an embodiment of the present disclosure, taken along line B-B' in FIG. 3.
FIG. 5 is a cross-sectional view of an electronic device according to an embodiment of the disclosure corresponding to line A-A' in FIG. 1.
FIG. 6 is a view illustrating an inner surface of a protection member according to an embodiment (first comparative example).
FIG. 7 is a view illustrating an inner surface of a protection member according to an embodiment (second comparative example).
FIG. 8 is a view illustrating an inner surface of a protection member according to an embodiment of the disclosure.
FIG. 9 is a view illustrating an electrostatic discharge path (ESD path) in the protection member according to an embodiment of the disclosure.
FIG. 10 is a view illustrating a conductive portion of a side surface member and a protection member adjacent thereto, according to an embodiment of the disclosure.
FIG. 11 is a cross-sectional view of an electronic device including a protection member corresponding to line D-D' of FIG. 10, according to an embodiment of the disclosure.
FIG. 12 is a cross-sectional view of an electronic device including a protection member corresponding to the line E-E' of FIG. 10, according to an embodiment of the disclosure.
FIG. 13 is a cross-sectional view of an electronic device including a protection member corresponding to line F-F' of FIG. 10, according to an embodiment of the disclosure.
FIG. 14 is a view illustrating an equivalent circuit for a side surface member and a protection member according to an embodiment of the disclosure.
FIG. 15 is a view illustrating a conductive portion of a side surface member and a protection member adjacent thereto, according to an embodiment of the disclosure.
FIGS. 16A to 16I are views illustrating various embodiments of conductive portions of the disclosure.

Throughout the appended drawings, like reference numerals may be assigned to like parts, components, and/or structures.

### [Mode for Carrying out the Invention]

In an electronic device (e.g., a foldable electronic device), a physical separation space may be provided between components included in a display. The separation space may be provided to prevent interference between the components included in the display during a folding operation of the display. However, static electricity may be introduced through the separation space, which may cause damage to the display. A path of electrostatic discharge ESD flowing into the display (hereinafter, simply referred to as "static electricity ESD") may be fabricated by using a protection member (e.g., a decoration member) surrounding the display. However, as the area of the protection member increases, the volume of the electronic device may increase or the size of the actual display area of the display may decrease.

According to various embodiments of the disclosure described below with reference to detailed drawings, it is possible to provide an electronic device including an effective electrostatic discharge path even when a protection member is miniaturized so as not to reduce the size of the actual display area of a display.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

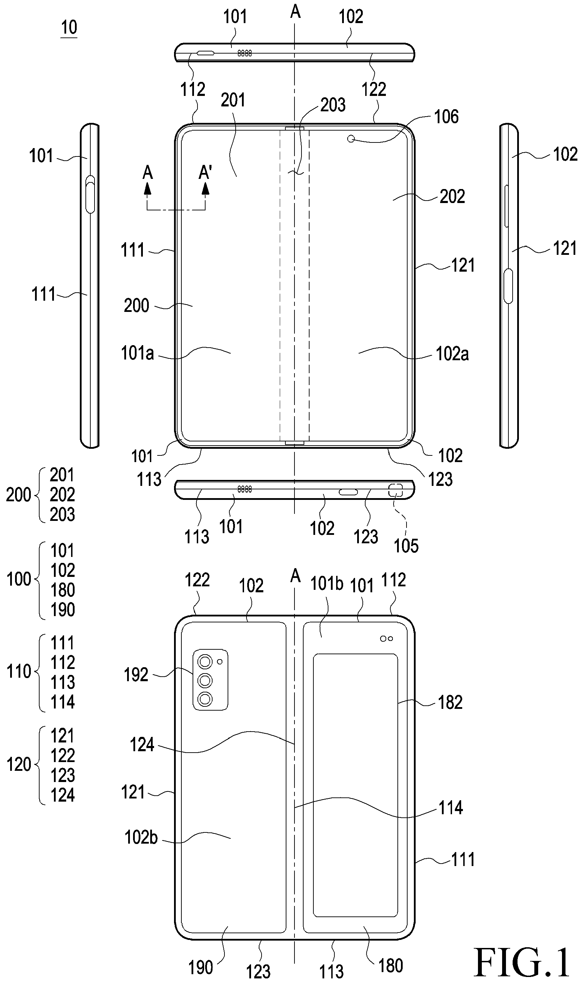

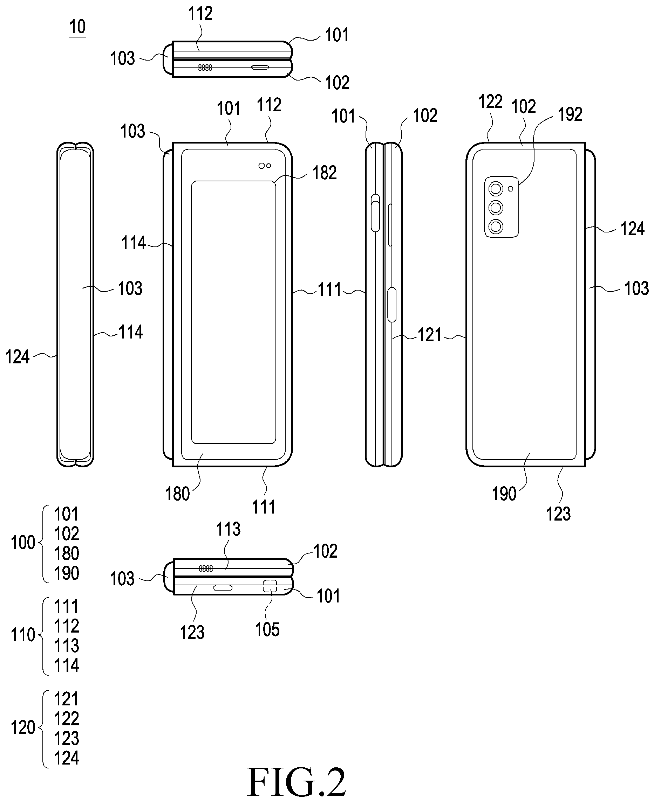

FIG. 1 is a view illustrating an unfolded state of an electronic device according to an embodiment of the disclosure. FIG. 2 is a view illustrating a folded state of the electronic device according to an embodiment of the disclosure.

Referring to FIGS. 1 and 2, the electronic device 10 is a foldable electronic device. Accordingly, the electronic device 10 includes a foldable housing 100 and a flexible or foldable display 200 (hereinafter, simply referred to as a "flexible display" 200) disposed in a space defined by the foldable housing 100. According to an embodiment, the electronic device 10 may further include a hinge cover 103 covering a foldable portion of the foldable housing 100. According to an embodiment, the surface on which the flexible display 200 is disposed may be defined as the front surface (e.g., a first surface 101a and a third surface 102a) of the electronic device 10. In addition, a surface opposite to the front surface may be defined as the rear surface (e.g., a second surface 101b and a fourth surface 102b) of the electronic device 10. The surface surrounding the space between the front surface and the rear surface may be defined as the side surface of the electronic device 10.

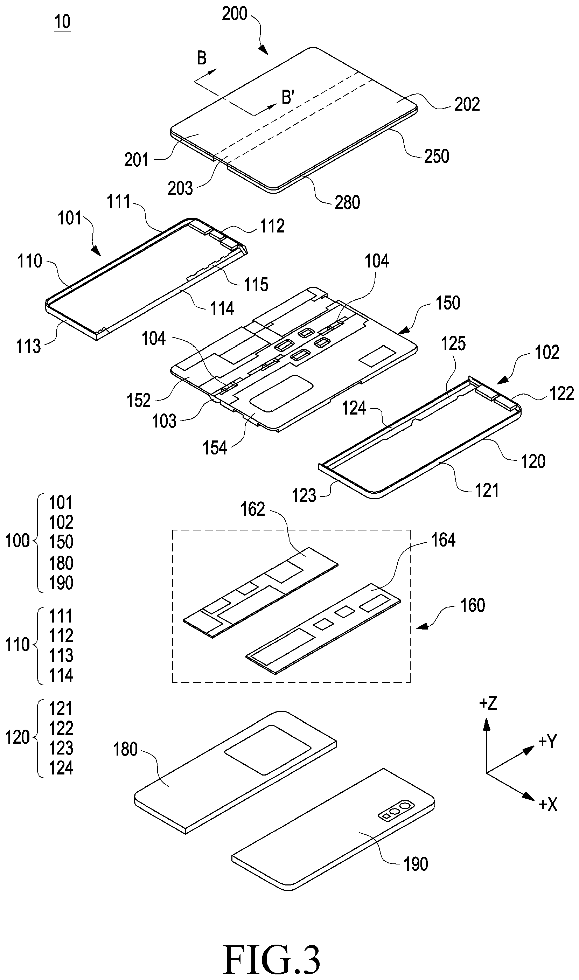

According to an embodiment, the foldable housing 100 may include a first housing structure 101, a second housing structure 102, a first rear surface cover 180, a second rear surface cover 190, and a hinge structure (e.g., the hinge structure 104 in FIG. 3). The first housing 101 may include a first side surface member 110 including a (1-1)^{th} side surface portion 111, a (1-2)^{th} side surface portion 112, a (1-3)^{th} side surface portion 113, and a (1-4)^{th} side surface portion 114, and the second housing 102 may include a second side surface member 120 including a (2-1)^{th} side surface portion 121, a (2-2)^{th} side surface portion 122, a (2-3)^{th} side surface portion 123, and a (2-4)^{th} side surface portion 124. The first side surface member 110 and the second side surface member 120 will be described in detail with reference to FIG. 3 below.

The foldable housing 100 of the electronic device 10 is not limited to the shape and assembly illustrated in FIGS. 1 and 2, but may be implemented by a combination and/or an assembly of different shapes or components. For example, in another embodiment, the first housing 101 and the first rear surface cover 180 may be integrally configured, and the second housing 102 and the second rear surface cover 190 may be integrally configured. According to an embodiment, the first housing 101 may include a first surface 101a connected to a hinge structure (e.g., the hinge structure 104 in FIG. 3) and oriented in a first direction and a second surface 101b oriented in a second direction opposite to the first direction. The second housing 102 may include a third surface 102a connected to the hinge structure (e.g., the hinge structure 104 in FIG. 3) and oriented in a third direction and a fourth surface 102b oriented in a fourth direction opposite to the third direction. The second housing 102 may rotate relative to the first housing 101 about the hinge structure (e.g., the hinge structure 104 in FIG. 3). Accordingly, the electronic device 10 may be transformable into the folded state or the unfolded state. In the folded state of the electronic device 10, the first surface 101a may face the third surface 102a, and in the unfolded state, the third direction may be the same as the first direction.

According to an embodiment, the first housing 101 and the second housing 102 may be disposed on opposite sides about the folding axis A and may have generally symmetrical shapes with respect to the folding axis A. As will be described later, the angle or distance between the first housing 101 and the second housing 102 may vary depending on whether the electronic device 10 is in the unfolded state, in the folded state, or in the intermediate state. According to an embodiment, unlike the first housing 101, the second housing 102 may further include the sensor area 106 in which various sensors are disposed, and the first housing and the second housing may have mutually symmetrical shapes in other areas. According to an embodiment, the folding axis A may be parallel to the rotation axis of the gear included in the hinge structure (e.g., the hinge structure 104 in FIG. 3), and may include a plurality of axes (e.g., two axes) parallel to each other in some embodiments. According to an embodiment, the first housing 101 and the second housing 102 may define together a recess that accommodates the flexible display 200.

According to an embodiment, the electronic device 10 may include a structure into which a digital pen (e.g., a stylus pen) is insertable. For example, a hole 105 into which the digital pen is insertable may be provided in the side surface of the first housing 101 or the side surface of the second housing 102 of the electronic device 10.

According to an embodiment, the first housing 101 and the second housing 102 may be at least partially made of a metal or non-metal material having rigidity of a level selected in order to support the flexible display 200. The at least a portion made of the metal material may provide a ground plane of the electronic device 10 and may be electrically connected to a ground line provided on a printed circuit board (e.g., the printed circuit board 160 in FIG. 3).

According to an embodiment, the sensor area 106 may be provided to have a predetermined area adjacent to one corner of the second housing 102. However, the arrangement, shape, and size of the sensor area 106 are not limited to the illustrated example. For example, in another embodiment, the sensor area 106 may be provided in another corner, any area between an upper end corner and a lower end corner of the second housing 102, or in the first housing 101. In an embodiment, components embedded in the electronic device 10 to execute various functions may be exposed to the front surface of the electronic device 10 through the sensor area 106 or one or more openings provided in the sensor area 106. In various embodiments, the components may include various types of sensors. The sensors may include, for example, at least one of a front camera, a receiver, or a proximity sensor.

According to an embodiment, the first rear surface cover 180 may be disposed on the rear surface of the electronic device 10 at one side of the folding axis A and may have, for example, a substantially rectangular periphery, which may be surrounded by the first housing 101. Similarly, the second rear surface cover 190 may be disposed on the rear surface of the electronic device 10 at the other side of the folding axis A, and may have a substantially rectangular periphery which may be surrounded by the second housing 102.

According to an embodiment, the first rear surface cover 180 and the second rear surface cover 190 may have substantially symmetrical shapes about the folding axis A. However, the first rear surface cover 180 and the second rear surface cover 190 do not necessarily have mutually symmetrical shapes, and in another embodiment, the electronic device 10 may include a first rear surface cover 180 and a second rear surface cover 190 having various shapes.

According to an embodiment, the first rear surface cover 180, the second rear surface cover 190, the first housing 101, and the second housing 102 may define a space in which various components (e.g., a printed circuit board or a battery) of the electronic device 10 may be disposed. According to an embodiment, one or more components may be disposed or visually exposed on the rear surface of the electronic device 10. For example, at least a portion of a sub-display (not illustrated) may be visually exposed through a first rear surface area 182 of the first rear surface cover 180. In another embodiment, one or more components or sensors may be visually exposed through a second rear surface area 192 of the second rear surface cover 190. In various embodiments, the sensors may include a proximity sensor and/or a rear camera.

According to an embodiment, a front camera, which is exposed on the front surface of the electronic device 10 through one or more openings provided in the sensor area 106 or a rear camera, which is exposed through the second rear surface area 192 of the second rear surface cover 190, may include one or more lenses, an image sensor, and/or an image signal processor. The flash may include, for example, a light-emitting diode or a xenon lamp. According to an embodiment, two or more lenses (such as an infrared camera, a wide-angle lens, an ultra-wide-angle lens, a macro lens, and a telephoto lens) and image sensors may be disposed on one surface of the electronic device 10.

Referring to FIG. 2, the hinge cover 103 may be disposed between the first housing 101 and the second housing 102 and may be configured to cover internal components (e.g., the hinge structure 104 in FIG. 3). According to an embodiment, the hinge cover 103 may be covered by a portion of the first housing 101 and a portion of the second housing 102, or may be exposed to the outside depending on the state of the electronic device 10 (the unfolded state (or flat state) or the folded state).

According to an embodiment, as illustrated in FIG. 1, when the electronic device 10 is in the unfolded state, the hinge cover 103 may not be exposed by being covered by the first housing 101 and the second housing 102. As another example, as illustrated in FIG. 2, when the electronic device 10 is in the folded state (e.g., the fully folded state), the hinge cover 103 may be exposed to the outside between the first housing 101 and the second housing 102. As another example, when the first housing 101 and the second housing 102 are in the intermediate state of being folded with a certain angle therebetween, the hinge cover 103 may be partially exposed to the outside between the first housing 101 and the second housing 102. However, the area exposed in this case may be smaller than that in the fully folded state. In an embodiment, the hinge cover 103 may include a curved surface.

FIG. 3 is an exploded perspective view of an electronic device according to an embodiment of the disclosure.

In the detailed description below from FIG. 3, the length direction of the electronic device 10 may be defined as the "Y-axis direction", the width direction may be defined as the "X-axis direction", and/or the height direction (thickness direction) may be defined as the "Z-axis direction". In the detailed description below, reference to the length direction, width direction, and/or height direction (or thickness direction) may indicate the length direction, width direction, and/or height direction (or thickness direction) of the electronic device 10. In some embodiments, "negative/positive (-/+)" may be referred to together with the Cartesian coordinate system illustrated in the drawings regarding the directions in which components are oriented. For example, referring to FIG. 3, the front surface of the electronic device 10 may be defined as a "surface oriented in the +Z-axis direction", and although not illustrated, the rear surface of the electronic device 10 may be defined as a "surface oriented in the -Z-axis direction". According to an embodiment, an arrangement relationship in the height direction of a certain component or another component, that is, the criterion of above/below may be based on the +Z-axis direction/-Z-axis direction. That is, when it is described that a certain component is disposed above another component, it may mean that the certain component is disposed in the +Z-axis direction with respect to the other component, and when it is described that a certain component is disposed below another component, it may mean that the certain component is disposed in the -Z axis direction with respect to the other component. Meanwhile, it is to be noted that even when a certain component is disposed above or below another component, it does not mean that the certain element is not entirely located above or below the entirety of the other component. For example, it is to be noted that a portion of the certain component may be located above a portion of the other component, while another portion of the certain component may be located below another portion of the other component. In the following description, it is to be noted that when it is described that a certain component overlaps (or is stacked on) another component, the description of the above-mentioned arrangement relationship in the height direction is applicable. In the description of the direction, when "negative/positive (-/+)" is not indicated, it may be interpreted as including both the + direction and the - direction unless otherwise defined. For example, the "X-axis direction" may be interpreted as including both the +X direction and the -X direction, and the "Y-axis direction" may be interpreted as including both the +Y direction and the -Y direction. In the description of the direction, description "being oriented in one axis among three axes of the Cartesian coordinate system" may include "being oriented in a direction parallel to the one axis. It is noted that this is based on the Cartesian coordinate system indicated in the drawings for brevity of description, and the description of these directions or components does not limit various embodiments of the disclosure.

Referring to FIG. 3, an electronic device 10 includes a foldable housing 100 and a flexible display 200. The electronic device 10 may include a hinge structure 104, a bracket assembly 150, and a printed circuit board 160.

The foldable housing 100 may include a first housing 101, a second housing 102, a bracket assembly 150, a first rear surface cover 180, and a second rear surface cover 190. All or some of the components of the electronic device 10 in FIG. 3 may be the same as all or some of the components of the electronic device 10 in FIG. 1 and/or FIG. 2.

The flexible display 200 may be disposed in a space defined by the foldable housing 100. For example, the flexible display 200 may be seated in a recess defined by the foldable housing 100, and may constitute most of the front surface of the electronic device 10. Accordingly, the front surface of the electronic device 10 may be defined as including the flexible display 200 and portions of the first housing 101 and the second housing 102 adjacent to the flexible display 200. In addition, the rear surface of the electronic device 10 may be defined as including the first rear surface cover 180, a portion the first housing 101 adjacent to the first rear surface cover 180, the second rear surface cover 190, and a portion of the second housing 102 adjacent to the second rear surface cover 190.

According to an embodiment, the term "flexible display" 200 may mean a display, at least a partial area of which is transformable into a planar surface or a curved surface. According to an embodiment, the flexible display 200 may include a folding area 203, a first area 201 disposed on one side of the folding area 203 (e.g., the left side of the folding area 203 illustrated in FIG. 1), and a second area 202 disposed on the other side of the folding area 203 (e.g., the right side of the folding area 203 illustrated in FIG. 1).

However, the area division of the flexible display 200 is illustrative, and the flexible display 200 may be divided into multiple areas (e.g., four or more areas or two areas) depending on the structure or functions thereof. Referring to FIG. 3, the areas of the flexible display 200 may be divided by the folding area 203 or the folding axis (axis A) extending in parallel to the Y axis. However, in another embodiment, the flexible display 200 may be divided with reference to another folding area (e.g., a folding area parallel to the X axis) or another folding axis (e.g., a folding axis parallel to the X axis). According to an embodiment, the flexible display 200 may be coupled to or disposed adjacent to a touch-sensitive circuit, a pressure sensor that is capable of measuring touch intensity (pressure), and/or a digitizer (not illustrated) configured to detect a magnetic field-type stylus pen.

According to an embodiment, the first area 201 and the second area 202 of the flexible display 200 may have generally symmetrical shapes about the folding area 203. However, unlike the first area 201, the second area 202 may include a notch cut due to the presence of the sensor area 106, but may have a shape symmetrical to the first area 201 in areas other than the sensor area. In other words, the first area 201 and the second area 202 may include portions having mutually symmetrical shapes and portions having mutually asymmetrical shapes.

Hereinafter, the operations of the first housing 101 and the second housing 102 according to the states of the electronic device 10 (e.g., a flat or unfolded state and a folded state) and respective areas of the flexible display 200 will be described.

In the disclosure, when it is described that the electronic device 10 is in the unfolded state (flat state) (e.g., FIG. 1), it may refer to the fully unfolded state (fully flat state) in which the first housing 101 and the second housing 102 form an angle of 180 degrees therebetween and are oriented in the same direction. The surface of the first area 201 and the surface of the second area 202 of the flexible display 200 may form 180 degrees relative to each other and may be oriented in the same direction (e.g., the front direction of the electronic device). In this case, the folding area 203 may define the same plane as the first area 201 and the second area 202.

In addition, in the disclosure, when it is described that the electronic device 10 is in the folded state (e.g., FIG. 3), it may refer to the fully folded state in which the first housing 101 and the second housing 102 face each other. The surface of the first area 201 and the surface of the second area 202 of the flexible display 200 may face each other while forming a small angle (e.g., an angle between 0 degrees and 10 degrees) relative to each other. In the following description, unless otherwise stated, an embodiment in which the first surface 201a and the surface of the second area 202 of the flexible display 200 form 0 degrees therebetween will be described. In this case, at least a portion of the folding area 203 may form a curved surface having a predetermined curvature.

According to an embodiment, when the electronic device 10 is in the intermediate state (e.g., FIG. 3), the first housing 101 and the second housing 102 may be disposed to form a certain angle relative to each other. The surface of the first area 201 and the surface of the second area 202 of the flexible display 200 may form an angle greater than that in the folded state and smaller than that in the unfolded state. At least a portion of the folding area 203 may form a curved surface having a predetermined curvature, and the curvature in this case may be smaller than that in the folded state.

According to an embodiment, when the electronic device 10 is in the unfolded state, the first direction in which the first surface 101a is oriented and the third direction in which the third surface 102a is oriented are parallel to the +Z direction, and the second direction in which the second surface 101b is oriented and the fourth direction in which the fourth surface 102b is oriented may be parallel to each other. According to an embodiment, in the state in which the electronic device 10 is folded, the first and fourth directions may be parallel to the +Z direction, and the second and third directions may be parallel to the -Z direction. Hereinbelow, unless otherwise stated, directions will be described with reference to the unfolded state of the electronic device 10.

The bracket assembly 150 may serve to support at least one component included in the electronic device 10. According to an embodiment, the bracket assembly 150 may include a first plate 152 and a second plate 154. A hinge structure 104 may be disposed between the first plate 152 and the second plate 154. When the hinge structure 104 is viewed from the outside, the hinge structure 104 may be covered by a hinge cover (e.g., the hinge cover 103 in FIG. 2). According to an embodiment, a printed circuit board (e.g., a flexible printed circuit board (FPCB)) may be disposed on the bracket assembly 150 across the first plate 152 and the second plate 154. For example, each of the first housing 101 and the second housing 102 may include one or more electronic components, and the one or more electronic components disposed in each of the first housing 101 and the second housing 102 may be electrically connected to each other by the FPCB.

According to an embodiment, the printed circuit board 160 may include a first circuit board 162 disposed on the first plate 152 and a second circuit board 164 disposed on the second plate 154. The first circuit board 162 and the second circuit board 164 may be disposed in a space defined by the bracket assembly 150, the first housing 101, the second housing 102, the first rear surface cover 180, and the second rear surface cover 190. Components for implementing various functions of the electronic device 10 may be mounted on the first circuit board 162 and the second circuit board 164.

According to an embodiment, the first housing 101 and the second housing 102 may be assembled in a manner of being respectively coupled to opposite sides of the bracket assembly 150. According to an embodiment, the first housing 101 may include a first side surface member 110 surrounding at least a portion of the side surface of the first plate 152, and the second housing 102 may include a second side surface member 121 surrounding at least a portion of the side surface of the second plate 154. According to an embodiment, the bracket assembly 150 may be integrally coupled with the first side surface member 110 and/or the second side surface member 120.

According to an embodiment, the first housing 101 may include a first rotation support surface 115, and the second housing 102 may include a second rotation support surface 125, which corresponds to the first rotation support surface 115. The first rotation support surface 115 and the second rotation support surface 125 may include curved surfaces corresponding to the curved surface included in the hinge cover 103. According to an embodiment, when the electronic device 10 is in the unfolded state (e.g., the electronic device in FIG. 1), the first rotation support surface 115 and the second rotation support surface 125 may cover the hinge cover 103, and the hinge cover 103 may not be exposed or may be minimally exposed to the rear surface of the electronic device 10. As another example, when the electronic device 10 is in the folded state (e.g., the electronic device in FIG. 2), the first rotation support surface 115 and the second rotation support surface 125 may rotate along the curved surface included in the hinge cover 103, and the hinge cover 103 may be maximally exposed to the rear surface of the electronic device 10.

According to an embodiment, the first side surface member 110 of the first housing 101 may include a (1-1)^{th} side surface portion 111 extending in parallel to the folding axis A. In addition, the first side surface member 110 may include a (1-2)^{th} side surface portion 112 extending from a first end of the (1-1)^{th} side surface portion 111 and perpendicular to the folding axis A. In addition, the first side surface member 110 may include a (1-3)^{th} side surface portion 113 extending from a second end of the (1-1)^{th} side surface portion 111 and perpendicular to the folding axis A. In addition, the first side surface member 110 may include a (1-4)^{th} side surface portion 114 extending between the (1-2)^{th} side surface portion 112 and the (1-3)^{th} side surface portion 113 and parallel to the folding axis A and the (1-1)^{th} side surface portion 111. The (1-1)^{th} side surface portion 111, the (1-2)^{th} side surface portion 112, the (1-3)^{th} side surface portion 113, and the (1-4)^{th} side surface portion 114 may surround at least a portion between the first surface 101a and the second surface 101b and may be perpendicular to the first direction or the second direction.

According to an embodiment, the second side surface member 120 of the second housing 102 may include a (2-1)^{th} side surface portion 121 extending in parallel to the folding axis A. In addition, the second side surface member 120 may include a (2-2)^{th} side surface portion 122 extending from a first end of the (2-1)^{th} side surface portion 121 and perpendicular to the folding axis A. In addition, the second side surface member 120 may include a (2-3)^{th} side surface portion 123 extending from a second end of the (2-1)^{th} side surface portion 121 and perpendicular to the folding axis A. In addition, the second side surface member 120 may include a (2-4)^{th} side surface portion 124 extending between the (2-2)^{th} side surface portion 122 and the (2-3)^{th} side surface portion 123 and parallel to the folding axis A and the (2-1)^{th} side surface portion 121. The (2-1)^{th} side surface portion 121, the (2-2)^{th} side surface portion 122, the (2-3)^{th} side surface portion 123, and the (2-4)^{th} side surface portion 124 may surround at least a portion between the third surface 102a and the fourth surface 102b and may be perpendicular to the third direction or the fourth direction.

In describing the embodiments of the disclosure, the first housing 101 and the second housing 102 may be individually indicated and described, but a description of the first housing 101 may be applicable to a description of the second housing 102. From this point of view, a description of the components included in the first housing 101 may also be applicable to a description of the components included in the second housing 102. For example, in the following description made with reference to the drawings, the (1-1)^{th} side surface portion 111 of the first side surface member 110 may mainly described, and the description thereof may also be applicable to the (2-1)^{th} side surface portion 121 of the second side surface member 120. As another example, a description of the (1-2)^{th} side surface portion 112 of the first side surface member 110 may be applicable to the (2-2)^{th} side surface portion 122 of the second side surface member 120, a description of the (1-3)^{th} side surface portion 113 of the first side surface member 110 may be applicable to the (2-3)^{th} side surface portion 123 of the second side surface member 120, and a description of the (1-4)^{th} side surface portion 114 of the first side surface member 110 may also be applicable to the (2-4)^{th} side surface portion 124 of the second side surface member 120. According to an embodiment, the (1-1)^{th} side surface portion 111 and the (2-1)^{th} side surface portion 121 may be collectively referred to as the first side surface portions 111 and 121, and the (1-2)^{th} side surface portion 112 and the (2-2)^{th} side surface portion 122 may be collectively referred to as second side surface portions 112 and 122. In addition, the (1-3)^{th} side surface portion 113 and the (2-3)^{th} side surface portion 123 may be collectively referred to as the third side surface portions 113 and 123, and the (1-4)^{th} side surface portion 114 and the (2-4)^{th} side surface portion 124 may be collectively referred to as fourth side surface portions 114 and 124.

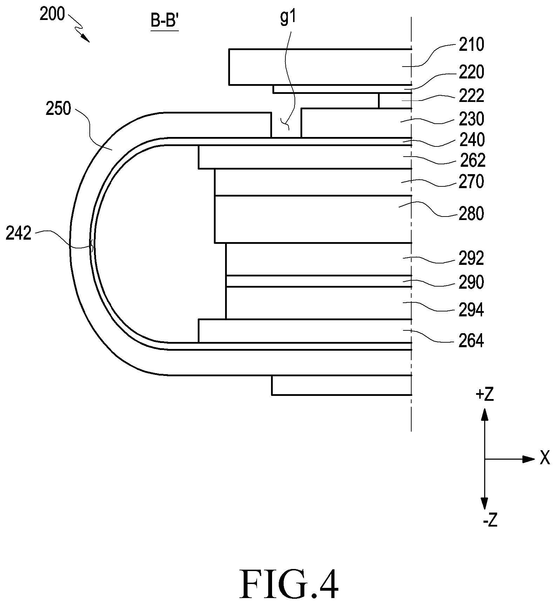

The above-mentioned first side surface member 110 and/or second side surface member 120 may be configured to at least partially surround the flexible display 200. Hereinafter, the structure of the flexible display 200 will be described in detail with reference to FIG. 4.

FIG. 4 is a cross-sectional view of an embodiment of the disclosure taken along line B-B' in FIG. 3.

Referring to FIG. 4, the flexible display 200 may include components for visually providing information to the outside (e.g., a user) of the electronic device 10. All or some of the components of the flexible display 200 in FIG. 4 may be the same as those of the flexible display 200 in FIGS. 1 and 3. Hereinafter, a detailed structure of the flexible display 200 is for the flexible display 200 disposed at a position corresponding to the (1-1)^{th} side surface portion 111 of the first housing 101. The following description may be similarly applicable to the (2-1)^{th} side surface portion 121 of the second housing 102.

According to an embodiment, the flexible display 200 may include at least one of a protection film 210 configured to protect the outer surface of the flexible display 200, a window member 220 disposed under the protection film 210 (e.g., in the -Z direction), a polarizing layer 230 disposed on the window member 220 via an adhesive 222, a display panel 240 disposed under the polarizing layer 230 and configured to display visual information, a bending protection layer (BPL) 250 configured to protect the display panel 240, a first protection film 262 disposed under the display panel 240, a cushion layer 270 disposed under the first protection film 262, a display support plate 280 disposed under the cushion layer 270, a column spacer 290 causing substrates (e.g., a color filter substrate 292 and a TFT substrate 294) to be separated from each other, or a second protection film 264. FIG. 4 may be a view schematically illustrating an arrangement relationship of components. Accordingly, it is to be noted that the shapes or dimensions (e.g., thickness) of components included in the flexible display 200 of the disclosure are not limited through the drawing of FIG. 4.

According to an embodiment, at least a portion of the window member 220 may be made of a material that is substantially transparent and flexible. For example, the window member 220 may be made of ultra-thin glass (UTG) or polyimide film. The display panel 240 may be exposed to the outside of the electronic device 10 through the window member 220.

According to an embodiment, a portion of the display panel 240 may be curved. The curved portion of the display panel 240 may be referred to as a bending portion 242. According to an embodiment, the bending portion 242 may be electrically connected to an electronic component (e.g., a display drive circuit). According to an embodiment, the display panel 240 may extend through the bending portion 242, and may surround at least a portion of other components of the display 200 (e.g., the cushion layer 270 or the display support plate 280). According to an embodiment, the position where the bending portion 242 is disposed may correspond to the first side surface portions 111 and 121 of the foldable housing 100.

According to an embodiment, the bending protection layer 250 may reduce tensile stress applied to the display panel 240. According to an embodiment, the bending protection layer 250 may extend along the bending portion 242 of the display panel 240. The bending protection layer 250 may support the bending portion 242 so that the bent portion 242 is curved along a neutral plane.

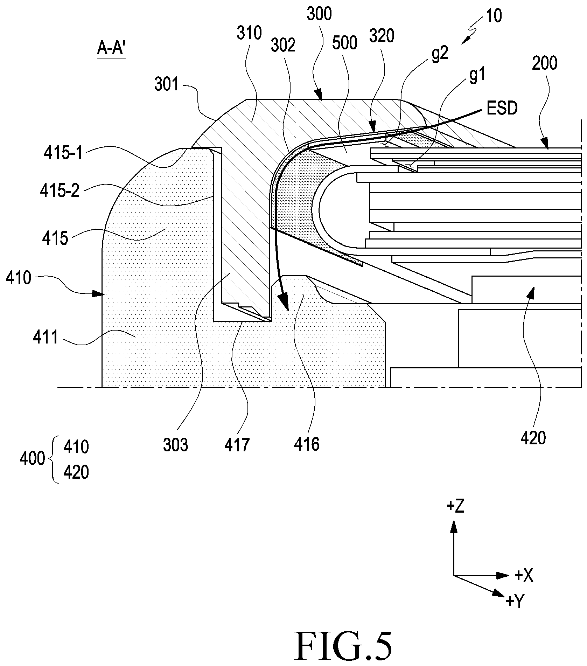

According to an embodiment, the display 200 may include a first separation space g1. At least a portion of the first separation space g1 may be surrounded by the display panel 240, the bending protection layer 250, and the polarizing layer 230. For example, the bending protection layer 250 and the polarizing layer 230 may be disposed on the display panel 240 to be spaced apart from each other in the width direction of the electronic device 10 (e.g., the X-axis direction). The first separation space g1 is a portion that may be physically exposed to the outside of the electronic device (e.g., the electronic device 10 in FIG. 1), and when there is no discharge structure, static electricity may flow into the display panel 240 through the first separation space g1. A structure for reducing static electricity flowing into the display panel 240 through the first separation space g1 will be described in detail below with reference to FIG. 5.

FIG. 5 is a cross-sectional view of an electronic device according to an embodiment of the disclosure corresponding to line A-A' in FIG. 1.

Referring to FIG. 5, an electronic device 10 includes a flexible display 200 (e.g., the flexible display 200 in FIG. 4), a protection member 300, and a side surface member 410. The side surface member 410 may be part of a support member 400. All or some of the components of the support member 400 of FIG. 5 may be the same as those of the foldable housing 100 of FIG. 3.

According to an embodiment, the support member 400 may support components of the electronic device 10. For example, the support member 400 may support the display 200. According to an embodiment, the support member 400 may accommodate electronic components of the electronic device 10. For example, an electronic component (e.g., a battery (not illustrated)) of the electronic device 10 may be disposed on the support member 400. According to an embodiment, the support member 400 may define a portion of the outer surface of the electronic device 10.

According to an embodiment, the support member 400 may include the side surface member 410 and/or a bracket assembly 420. The bracket assembly 420 is a part that supports the display 200, and all or some of the bracket assembly may be the same as those of the bracket assembly 150 in FIG. 3. The side surface member 410 is a part that defines the side surface of the electronic device 10. For example, the side surface member 410 may refer to at least one of or all of the first side surface portions 111 and 121, the second side surface portions 112 and 122, the third side surface portions 113 and 123, and/or the fourth side surface portions 114 and 124 of FIG. 1.

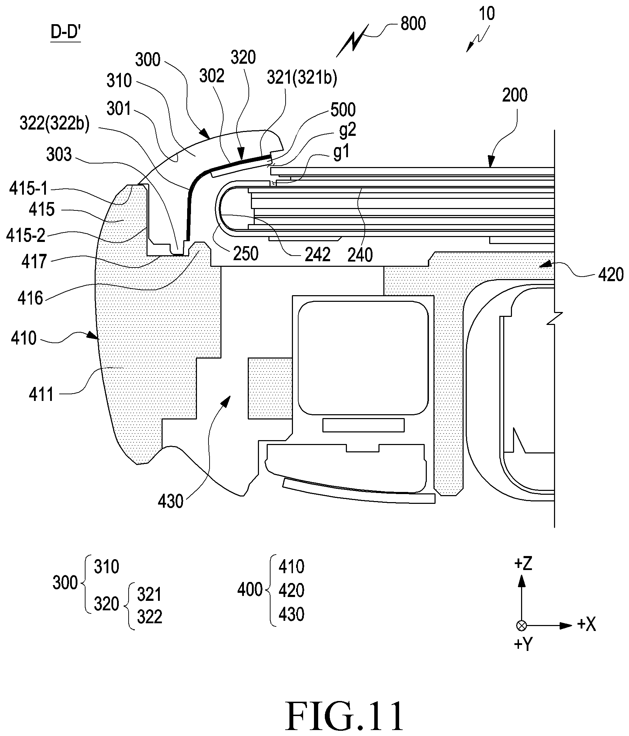

In FIGS. 11, 12, and 13, which will be described below, including FIG. 5, of the first side surfaces 111 and 121, a first side surface portion 411 (e.g., the (1-1)^{th} side surface portion 111) included in the first housing 101 is illustrated. Hereinafter, the description of the first side surface portion 411 (e.g., the (1-1)^{th} side surface portion 111) may be equally applicable to the (2-1)^{th} side surface portion 121.

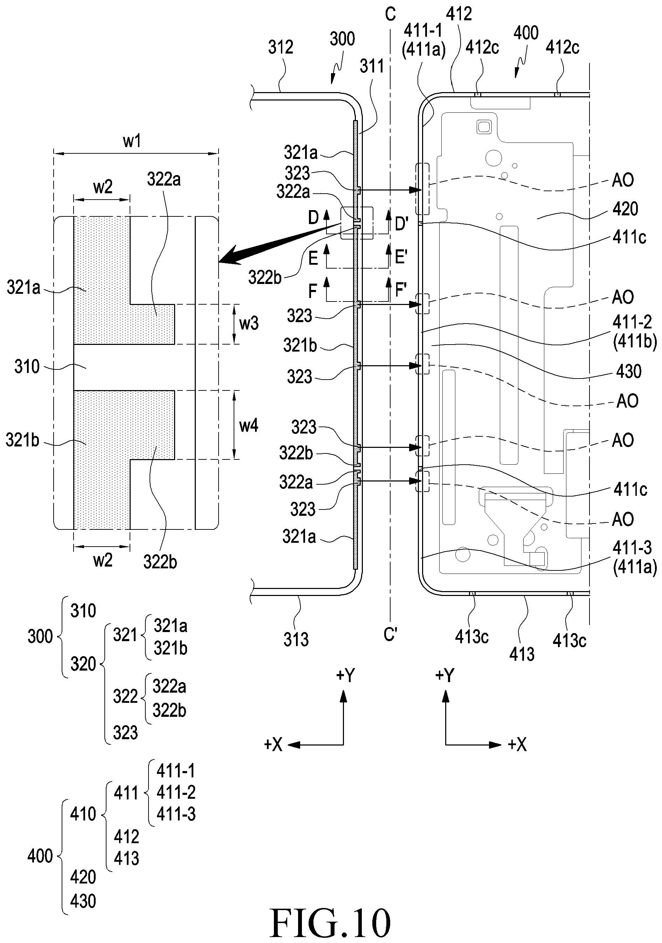

According to an embodiment, the support member 400 may be made of a mixture of a conductive material and a non-conductive material. For example, the support member 400 may include at least a portion of a metal area made of metal (e.g., stainless steel or aluminum) and at least a portion of a resin area made of resin (e.g., plastic). According to an embodiment, the resin area may be fabricated through injection molding. According to an embodiment, the side surface member 410 and the bracket assembly 420 may at least partially include the metal area. According to an embodiment, the support member 400 may further include a resin portion (e.g., a resin portion 430 described later with reference to FIG. 10). This resin portion may correspond to the resin area.

According to an embodiment, the metal area of the support member 400 may provide a part of the discharge path. For example, the metal area of the side surface member 410 may provide a ground plane, and may be electrically connected to a ground line provided on a printed circuit board (e.g., the printed circuit board 160 in FIG. 3). The shapes of the side surface member 410, the bracket assembly 420, and the resin portion (e.g., the resin portion 430 to be described later with reference to FIG. 10) of the support member 400 may vary in some embodiments, and their arranged positions may also vary in some embodiments.

According to an embodiment, the support member 400 may include a side wall 415 and a protrusion 416. The side wall 415 may be a part that defines the exterior of the side surface member 410 included in the support member 400. According to an embodiment, the side wall 415 may include a first side wall portion 415-1 and a second side wall portion 415-2. The first side wall portion 415-1 may be oriented in the height direction of the electronic device 10 (the Z-axis direction), and the second side wall portion 415-2 may be oriented in the width direction (the X-axis direction). According to an embodiment, the second side wall portion 415-2 may face the inner space of the electronic device 10. The protrusion 416 may protrude by a predetermined height in the height direction of the electronic device 10 (the Z-axis direction) from the metal area of the side surface member 410 at a position spaced apart from the side wall 415 by a predetermined distance in the width direction of the electronic device 10 (the X-axis direction). The support member 400 may further include a seating portion 417 between the side wall 415 and the protrusion 416.

According to an embodiment, the protection member 300 may surround at least a portion of the display 200. For example, the protection member 300 may surround at least a portion of the space between the support member 400 and the display 200. According to an embodiment, the protection member 300 may at least partially overlap the side wall 415, the protrusion 416, and/or the seating portion 417 of the support member 400. According to an embodiment, the protection member 300 may be spaced apart from the display 200 in order to prevent the protection member from coming into contact with the display 200 when the electronic device 10 is folded. For example, the protection member 300 may be spaced apart from the display 200 in the height direction of the electronic device 10 (e.g., the Z-axis direction) and/or the width direction of the electronic device 10 (e.g., the X-axis direction).

The protection member 300 includes an outer surface 301 facing the outside of the electronic device 10 and an inner surface 302 facing at least a portion of the display 200 inside the electronic device 10. The inner surface 302 may include a first inner surface facing the front surface of the display 200 and a second inner surface oriented in a different direction from the first inner surface. For example, the second inner surface may face the side surface of the display 200 (e.g., the bending portion 242 and/or the bending protection layer 250 in FIG. 4). The protection member 300 may include an extension 303 extending toward the support member 400 of the electronic device 10. According to an embodiment, the extension 303 of the protection member 300 may be seated on the seating portion 417 between the side wall 415 and the protruding part 416 of the support member 400. According to an embodiment, the protection member 300 may face the first side wall portion 415-1 and the second side wall portion 415-2 of the side wall 415 of the support member 400.

The protection member 300 includes a non-conductive portion 310 and a conductive portion 320. For example, the non-conductive portion 310 may be made of a resin material (e.g., plastic). The non-conductive portion 310 may be provided on the outer surface 301 and the extension 303 of the protection member 300, and the conductive portion 320 may be provided on the inner surface 302 of the protection member 300. According to an embodiment, the electrical conductivity of the non-conductive portion 310 may be lower than that of the metal area of the support member 400 or the conductive portion 320.

According to an embodiment, the conductive portion 320 of the protection member 300 may configure a discharge path of the electronic device 10. For example, the conductive portion 320 may transfer, to the ground, power (e.g., static electricity ESD) provided to the electronic device 10 from the outside of the electronic device 10. For example, the conductive portion 320 may be electrically connected to the metal area of the support member 400. The phrase "electrically connected" as used herein may refer to a structure in which a certain component and another component are directly connected to (e.g., being in contact with) each other or a structure in which a certain component is so close to another component that a current applied to the certain component can cause the movement of electrons in the other component.

The conductive portion 320 is disposed on the inner surface 302 of the protection member 300. The conductive portion 320 may face the inner surface 302 of the protection member 300 that faces a bending protection layer (e.g., the bending protection layer 250 in FIG. 4) or a bending portion (e.g., the bending portion 242 in FIG. 4) of the display 200. According to an embodiment, the conductive portion 320 may face the bending protection layer 250 and/or the bending portion 242. Static electricity ESD flowing into the first separation space g1 may be reduced by the conductive portion 320 facing the bending protection layer 250 and/or the bending portion 242. According to an embodiment, the conductive portion 320 may extend in parallel to the folding axis (e.g., the folding axis A in FIG. 1) of the electronic device 10. For example, the conductive portion 320 may extend along the length direction of the electronic device 10 (e.g., the Y-axis direction).

According to an embodiment, the electronic device 10 may include a non-conductive member 500 between the protection member 300 and the display 200. According to an embodiment, the non-conductive member 500 may block foreign substances from entering a second separation space g2 between the protection member 300 and the display 200. For example, the non-conductive member 500 may be an elastic porous material (e.g., sponge) or a buffer material (e.g., mohair or brush).

According to an embodiment, the non-conductive member 500 may be disposed on the inner surface 302 of the protection member 300. According to an embodiment, the non-conductive member 500 may be disposed on a portion of the protection member 300 that faces the front surface of the display 200. According to an embodiment, the non-conductive member 500 may limit the flow of static electricity ESD transferred to the conductive portion 320 of the protection member 300. For example, the non-conductive member 500 may prevent static electricity ESD from flowing on a path toward the display 200 through the conductive portion 320 of the protection member 300 and may guide the static electricity ESD to move toward the extension 303 of the protection member 300.

FIG. 5 illustrates the structure in which the protection member 300, the support member 400, and the non-conductive member 500 of the electronic device 10 are located at the left side of the electronic device 10 of FIG. 1 (e.g., the cross section of the first housing 101 (e.g., line A-A'), but this is merely an example for description, and the structure of the disclosure is not limited thereto.

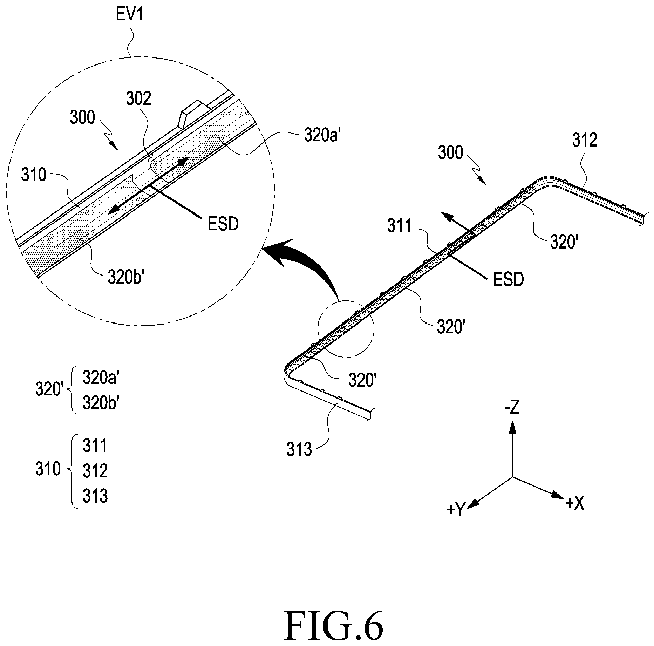

FIG. 6 is a view illustrating an inner surface of a protection member according to an embodiment (first comparative example).

According to an embodiment, the protection member 300 may have a shape in which is width is generally small compared to its length and may be fabricated as a frame structure corresponding to a side surface (e.g., the first side surface member 110) of an electronic device (e.g., the electronic device 10 in FIG. 1). Referring to FIG. 6, the protection member 300 may include peripheral portions 311, 312, and 313 corresponding to a first side surface portion (e.g., the first side surface portion 111 in FIG. 1), a second side surface portion (e.g., the second side surface portion 112 in FIG. 1), and a third side surface portion (e.g., the third side surface portion 113 in FIG. 1) of a side surface member (e.g., the first side surface member 110). The protection member is not necessarily limited thereto, and may also include a peripheral portion corresponding to a fourth side surface portion (e.g., the fourth side surface portion 114 in FIG. 1).

Referring to FIG. 6, the protection member 300 may include a non-conductive portion 310 through which static electricity ESD does not pass and a conductive portion 320' through which static electricity ESD is capable of passing. The non-conductive portion 310 may be a portion including most of the entire volume of the protection member 300. The conductive portion 320' illustrated in FIG. 6 may be disposed on the inner surface 302 of the protection member 300. According to an embodiment, the conductive portion 320' may be provided on the inner surface 302 of the protection member 300 to overlap the non-conductive portion 310. The non-conductive portion 310 may be an element that limits discharge of static electricity ESD on the inner surface 302 of the protection member 300. Although the volume of the conductive portion 320' may be small compared to the volume of the non-conductive portion 310, a discharge path of static electricity ESD may be provided on the inner surface 302 of the protection member 300. A description of the conductive portion 320' of FIG. 6 overlapping that of the conductive portion 320 described above with reference to FIG. 5 may be omitted.

According to an embodiment, the conductive portion 320' may include at least one of conductive tape, conductive sheet, conductive film, or conductive fabric. According to an embodiment, the conductive tape (or conductive sheet or conductive film) may be tape (or sheet or film) containing a conductive metal (e.g., at least one of copper, nickel, gold, silver, or aluminum). According to an embodiment, the conductive fabric may be made of a woven fabric or a non-woven fabric. The conductive fabric may include threads and fibers of a metal (e.g., at least one of copper, nickel, gold, silver, or aluminum).

The inner surface 302 of the protection member 300 illustrated in FIG. 6 may be substantially configured with a non-conductive portion 310 and a conductive portion 320'. According to an embodiment, the conductive portion 320' may overlap the surface of the non-conductive portion 310 to form the inner surface 302 of the protection member 300. According to an embodiment, on the inner surface 302 of the protection member 300, the area in which the conductive portion 320' is overlapped may occupy a significant portion compared to the area of the non-conductive portion 310. For example, on the inner surface 302 of the protection member 300, the conductive portion 320' may overlap the non-conductive portion 310 in an area of about 90% or more along the length direction of the protection member 300 and may overlap in an area of about 80% or more along the width direction of the protection member 300. In the description made with reference to FIG. 6, it is to be noted that numerical limitations are only for understanding, and do not limit the scope to which embodiments of the disclosure are applied. Since the inner surface 302 of the protection member 300 may include a curved surface, the "width of the conductive portion 320" disposed on the inner surface 302 of the protection member 300 does not necessarily include only the width of a portion extending in a direction parallel to the width direction of the electronic device (e.g., the electronic device 10 in FIG. 5) (the X-axis direction), but may include widths of portions extending in various directions on the XZ plane between the X axis and the Z axis with reference to the coordinate axes in FIG. 6.

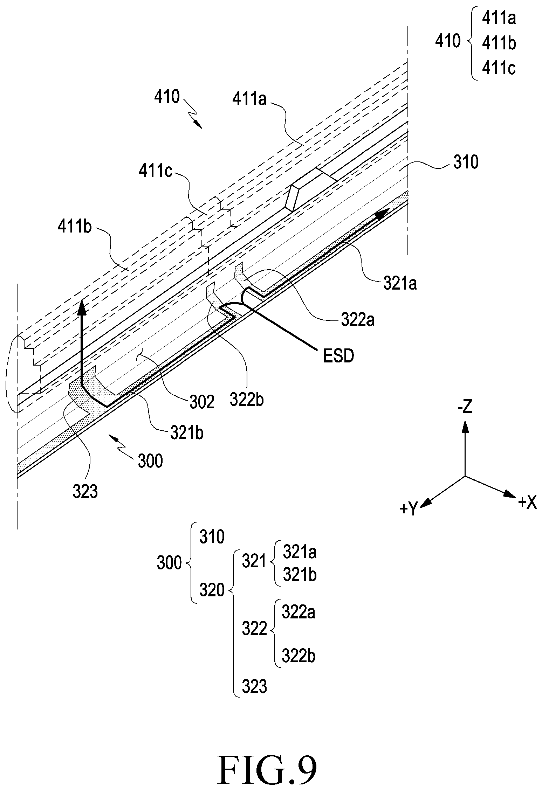

According to an embodiment, static electricity ESD introduced into a position where the conductive portion 320' of the protection member 300 is provided may be discharged toward the side surface member 410 of the support member 400. In addition, as illustrated in a first enlarged view 1 (EV1) of FIG. 6, a large area of the conductive portion 320' is secured in the protection member 300. Therefore, even static electricity ESD introduced into a position where the conductive portion 320' is not provided (e.g., a position corresponding to the split portion 411c to be described later with reference to FIG. 9) may be easily guided in the length direction of the protection member 300 and/or may be easily discharged toward the side surface member 410 of the support member 400.

However, for example, when the thickness of the protection member 300 including the conductive portion 320' illustrated in FIG. 6 is reduced as one of measures for making the design of the electronic device 10 more beautiful, it may be difficult to secure, in the protection member 300, a sufficient width of the conductive portion 320' to effectively discharge static electricity. In addition, when the conductive portion 320' is made of tape, in the protection member 300 including the conductive portion 320' illustrated in FIG. 6, the deviation in radiation performance of the metal antenna disposed around the conductive portion 320' may increase due to the deviation in the process of attaching the tape. According to an embodiment, the "metal antenna" may be a configuration in which the side surface member 410 of the support member 400 includes a metal area and operates as an antenna. Referring to FIG. 6, the conductive portion 320' may include a conductive portion 320a' disposed at a position corresponding to an antenna area (e.g., a metal antenna) of the side surface member 410 and a conductive portion 320b' disposed at a position corresponding to a non-antenna area. The "antenna area" may be an area in which the corresponding area is used as an antenna radiator, and the "non-antenna area" may be an area in which the corresponding area is not utilized as an antenna radiator. In addition, the protection member 300 including the conductive portion 320' illustrated in FIG. 6 may cause an effect similar to the presence of other conductors around the metal antenna due to the large area of the conductive portion 320', resulting in deterioration of antenna radiation performance.

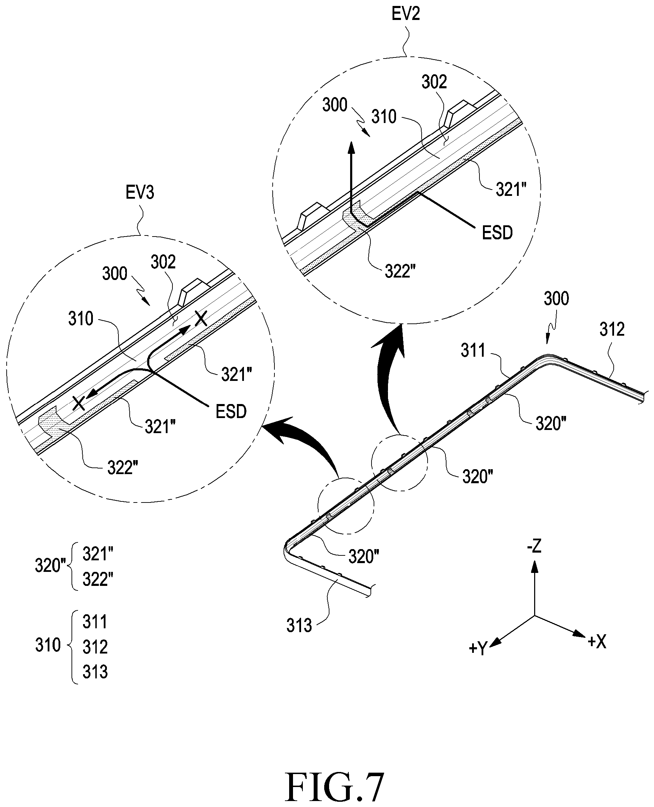

FIG. 7 is a view illustrating an inner surface of a protection member according to an embodiment (second comparative example).

Like the protection member 300 illustrated in FIG. 6, the protection member 300 illustrated in FIG. 7 may also have a shape in which its width is generally small compared to its length and may be fabricated as a frame structure corresponding to a side surface member (e.g., the first side surface member 110) of an electronic device (e.g., the electronic device 10 in FIG. 1). Referring to FIG. 7, the protection member 300 may include peripheral portions 311, 312, and 313 corresponding to a first side surface portion (e.g., the first side surface portion 111 in FIG. 1), a second side surface portion (e.g., the second side surface portion 112 in FIG. 1), and a third side surface portion (e.g., the third side surface portion 113 in FIG. 1) of a side surface member (e.g., the first side surface member 110). The protection member is not necessarily limited thereto, and may also include a peripheral portion corresponding to a fourth side surface portion (e.g., the fourth side surface portion 114 in FIG. 1). Hereinafter, in describing the embodiment of FIG. 7, a description overlapping that of the embodiment described above with reference to FIG. 6 may be omitted for convenience.

Referring to FIG. 7, the protection member 300 may include a non-conductive portion 310 through which static electricity ESD does not pass and a conductive portion 320" through which static electricity ESD is capable of passing. The non-conductive portion 310 may be a portion including most of the entire volume of the protection member 300.

In FIG. 7, it may be possible to provide a protection member 300 including a conductive portion 320" having a smaller area than the above-described conductive portion 320' on the inner surface 302 of the protection member 300.

The inner surface 302 of the protection member 300 illustrated in FIG. 7 may be substantially configured with a non-conductive portion 310 and a conductive portion 320". According to an embodiment, the conductive portion 320" may overlap the surface of the non-conductive portion 310 to form the inner surface 302 of the protection member 300. According to an embodiment, on the inner surface 302 of the protection member 300, the area in which the conductive portion 320" is overlapped may occupy a half or less of the area of the non-conductive portion 310. Alternatively, on the inner surface 302 of the protection member 300, the width of the portion in which the conductive portion 320" is overlapped may occupy a half or less of the width of the non-conductive portion 310. For example, on the inner surface 302 of the protection member 300, the conductive portion 320" may overlap the non-conductive portion 310 in an area of about 90% or more along the length direction of the protection member 300 and may overlap in an area of about 20% to 30% along the width direction of the protection member 300. According to an embodiment, the protection member 300 of FIG. 7 may further include a component in which the conductive portion 320" overlaps the non-conductive portion 310 in an area of about 80% or more along the width direction of the protection member 300. Meanwhile, in the description made with reference to FIG. 7, it is to be noted that numerical limitations are only for understanding, and do not limit the scope to which embodiments of the disclosure are applied.

According to an embodiment, the conductive portion 320" may be configured with a conductive pattern. Here, the conductive pattern may be fabricated through a layer direct structuring (LDS) method or a pad printing method. For example, the conductive portion 320" may be a pattern (or a plating layer) fabricated by coating a conductive metal (e.g., at least one of copper, nickel, gold, silver, or aluminum) on a pattern fabricated by using a laser. According to an embodiment, the conductive pattern may be fabricated by vapor-depositing (evaporating) a conductive material on the protection member 300. For example, the conductive portion 320" may be a film or coating obtained by vapor-depositing a conductive material (e.g., at least one of copper, nickel, gold, silver, or aluminum) on the inner surface 302 of the protection member 300.

Referring to FIG. 7, the conductive portion 320" may include a conductive portion 321" extending in a direction parallel to the length direction of an electronic device (e.g., the electronic device 10 in FIG. 5), and a conductive portion 322" extending from the conductive portion 321" toward a side surface member (e.g., the side surface member 410 in FIG. 4) in parallel to the length direction of the electronic device. The conductive portion 321" extending in parallel to the length direction of the electronic device may guide static electricity ESD in the length direction of the protection member 300, and the conductive portion 322" extending toward the side surface member may discharge static electricity ESD toward the side surface member (e.g., the side surface member 410 in FIG. 4).

As illustrated in the second enlarged view 2 (EV2) of FIG. 7, static electricity ESD introduced into the protection member 300 at the position where the conductive portion 320" is disposed may be discharged toward the side surface member 410 of the support member 400. Since the protection member 300 illustrated in FIG. 7 includes the conductive portion 320" having a smaller area than the protection member 300 illustrated in FIG. 6 (e.g., including the conductive portion 321" having a smaller width in the width direction of the protection member 300), there may be fewer restrictions on reducing the width of the protection member 300, the deviation in radiation performance between adj acent metal antennas may be small, and the deterioration of radiation performance may be reduced and/or prevented. However, as illustrated in the third enlarged view 3 (EV3) illustrated in FIG. 7, since the area secured in the conductive portion 320" of the protection member 300 is small, static electricity ESD introduced into a position in which the conductive portion 320" is not provided (e.g., a position corresponding to the split portion 411c to be described later with reference to FIG. 9) may not be guided in the length direction of the protection member 300. In some cases, when static electricity ESD is introduced into a position where the conductive portion 320" is not provided (e.g., a position corresponding to the split portion 411c to be described later in FIG. 9), static electricity ESD may be introduced into the first separation space g1 rather than being guided to the side surface member 410 side, which may cause damage to the display 200.

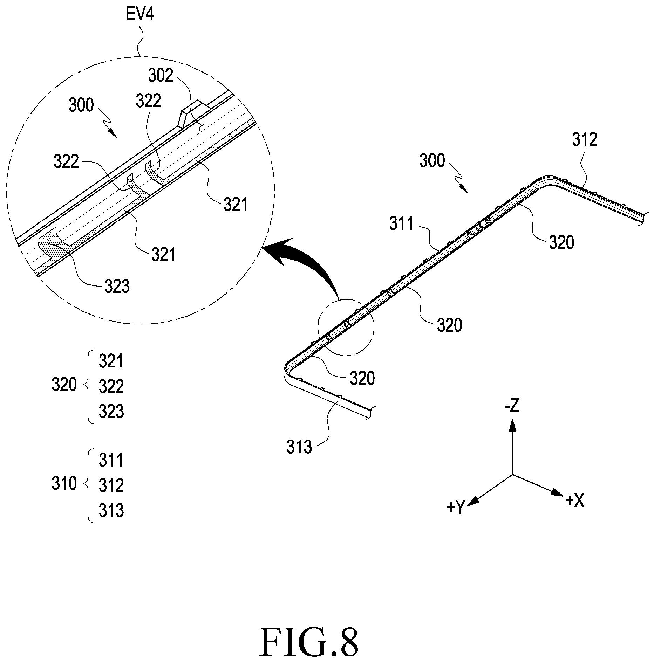

FIG. 8 is a view illustrating an inner surface of a protection member according to an embodiment of the disclosure. FIG. 9 is a view illustrating an electrostatic discharge path (ESD path) in the protection member according to an embodiment of the disclosure.

Like the protection member 300 illustrated in FIG. 7, the protection member 300 illustrated in FIGS. 8 and 9 may also have a shape in which its width is generally small compared to its length and may be fabricated as a frame structure corresponding to a side surface member (e.g., the first side surface member 110) of an electronic device (e.g., the electronic device 10 in FIG. 1).

Referring to FIG. 8, the protection member 300 may include peripheral portions 311, 312, and 313 corresponding to a first side surface portion (e.g., the first side surface portion 111 in FIG. 1), a second side surface portion (e.g., the second side surface portion 112 in FIG. 1), and a third side surface portion (e.g., the third side surface portion 113 in FIG. 1) of a side surface member (e.g., the first side surface member 110). The protection member is not necessarily limited thereto, and may also include a peripheral portion corresponding to a fourth side surface portion (e.g., the fourth side surface portion 114 in FIG. 1).

In FIG. 8, it may be possible to provide a protection member 300 including a conductive portion 320 having a smaller area than the conductive portion 320' described above with reference to FIG. 6 on the inner surface 302 of the protection member 300.

The inner surface 302 of the protection member 300 illustrated in FIG. 8 may be substantially configured with a non-conductive portion 310 and a conductive portion 320. According to an embodiment, the conductive portion 320 may overlap the surface of the non-conductive portion 310 to form the inner surface 302 of the protection member 300. According to an embodiment, on the inner surface 302 of the protection member 300, the area in which the conductive portion 320 is overlapped may occupy a half or less of the area of the non-conductive portion 310. For example, on the inner surface 302 of the protection member 300, the conductive portion 320 may overlap the non-conductive portion 310 in an area of about 90% or more along the length direction of the protection member 300 and may overlap in an area of about 20% to 30% along the width direction of the protection member 300. According to an embodiment, the protection member 300 of FIG. 8 may further include a component in which the conductive portion 320 overlaps the non-conductive portion 310 in an area of about 80% or more along the width direction of the protection member 300. Meanwhile, in the description made with reference to FIG. 8, it is to be noted that numerical limitations are only for understanding, and do not limit the scope to which embodiments of the disclosure are applied.

Referring to FIG. 9, the protection member 300 may be disposed to overlap at least a portion of the side surface member 410 in a height direction of an electronic device (e.g., the electronic device 10 in FIG. 5) (the Z-axis direction). At this time, the side surface member 410 defines the side surface of a housing and includes a first portion 411a made of a conductive material, a second portion 411b made of a conductive material and electrically separated from the first portion 411a, and a split portion 411c made of an insulating material between the first portion 411a and the second portion 411b. According to an embodiment, in the electronic device (e.g., the electronic device 10 of FIG. 5), at least one of the first portion 411a and the second portion 411b of the side surface member 410 made of a conductive material may be used as a metal antenna radiator.

Referring to FIGS. 8 and 9 together, the protection member 300 may include a non-conductive portion 310 through which static electricity ESD does not pass and a conductive portion 320" through which static electricity ESD is capable of passing. The non-conductive portion 310 may be a portion including most of the entire volume of the protection member 300. According to an embodiment, to correspond to the split portion 411c provided to use a portion of the side surface member 410 as an antenna, the conductive portion 320 may also be separated into two or more conductive portions 320 rather than integrally extending in the length direction of the electronic device. For example, a position of a separation or gap between ends of a first conductive portion 321 of the conductive portion 320 extending in parallel to the length direction of the electronic device may correspond to the split portion 411c.

According to an embodiment, the conductive portion 320 may be configured with a conductive pattern. Here, the conductive pattern may be fabricated through a layer direct structuring (LDS) method or a pad printing method. For example, the conductive portion 320 may be a pattern (or a plating layer) fabricated by coating a conductive metal (e.g., at least one of copper, nickel, gold, silver, or aluminum) on a pattern fabricated by using a laser. According to an embodiment, the conductive pattern may be fabricated by vapor-depositing (evaporating) a conductive material on the protection member 300. For example, the conductive portion 320" may be a film or coating obtained by vapor-depositing a conductive material (e.g., at least one of copper, nickel, gold, silver, or aluminum) on the inner surface 302 of the protection member 300.

Referring to FIG. 8, the conductive portion 320 may include a first conductive portion 321 extending in parallel to the length direction of an electronic device (e.g., the electronic device 10 in FIG. 5) and a second conductive portion 322 extending toward the side surface member 410. The second conductive portion 322 extends in a direction orthogonal to the length direction of the electronic device (e.g., the electronic device 10 of FIG. 5). The first conductive portion 321 extending in parallel to the length direction of the electronic device may guide static electricity ESD in the length direction of the protection member 300, and the second conductive portion 322 extending toward the side surface member 410 may discharge static electricity ESD toward the side surface member (e.g., the side surface member 410 in FIG. 4).

Referring to FIG. 8, as illustrated in the enlarged view 4 (EV4), the electronic device 10 according to an embodiment of the disclosure may include a second conductive portion 322 extending from an end of the first conductive portion 321 toward the side surface member 410. Since the protection member 300 illustrated in FIG. 8 includes the conductive portion 320 having a smaller area than the protection member 300 illustrated in FIG. 6 (e.g., including the first conductive portion 321 having a smaller width in the width direction of the protection member 300) compared to the protection member 300 illustrated in FIG. 6, there may be fewer restrictions on reducing the width of the protection member 300, the deviation in radiation performance between adjacent metal antennas may be small, and the deterioration of radiation performance may be reduced and/or prevented. In addition, referring to FIG. 9, since the protection member 300 includes the second conductive portion 322 extending from an end of the first conductive portion 321 toward the side surface member 410, even when static electricity ESD is introduced into the position corresponding to the split portion 411c, the static electricity ESD may be discharged toward the side surface member 410 without being induced into the first separation space g1. The static electricity ESD introduced into the position corresponding to the split portion 411c may be captured by the second conductive portion 322 when passing through the periphery of the second conductive portion 322 and may flow into the first conductive portion 321. The second conductive portion 322 may serve as a bridge to transfer static electricity ESD to the first conductive portion 321. In order to discharge static electricity ESD, the wider width of the conductive portion 320 provided on the protection member 300 may be advantageous. In the disclosure, when the side surface member 410 is used as an antenna radiator by reducing the width of the first conductive portion 321 provided along the length direction of the protection member 300, it is possible to secure ESD discharge performance through the second conductive portion 322 provided at the position corresponding to the split portion 411c while minimizing the effect on the radiation performance of the antenna.

Referring to FIGS. 8 and 9 together, the first conductive portion 321 and the second conductive portion 322 according to an embodiment may be provided on both sides of the split portion 411c, respectively. In this case, the first conductive portion 321 and the second conductive portion 322 disposed on one side of the split portion 411c and the first conductive portion 321 and the second conductive portion 322 disposed on the other side may induce, in opposite directions, static electricity ESD introduced through the split portion 411c.

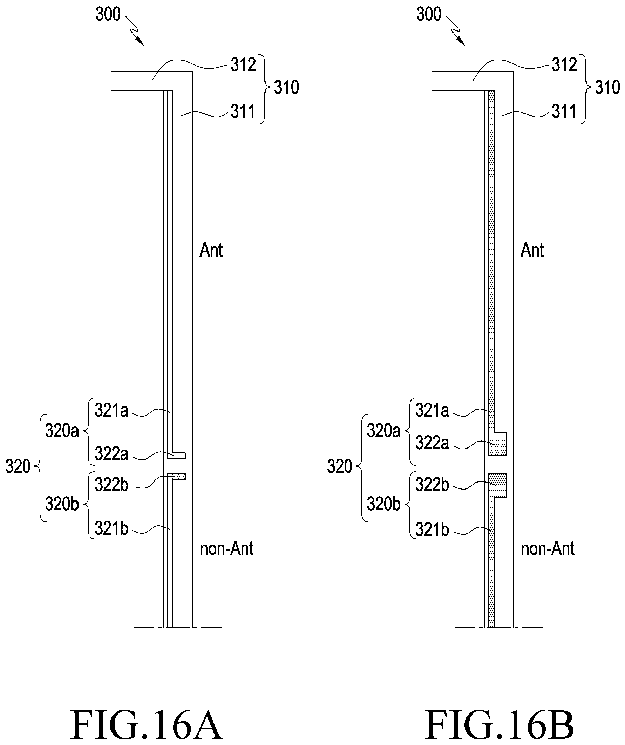

In some embodiments, the conductive pattern of the second conductive portion 322 may be freely fabricated to have various shapes and sizes in consideration of the charge amount of static electricity ESD introduced into the split portion 411c and the radiation performance of the metal antenna according to the use of the side surface member 410 as a metal antenna. According to an embodiment, the conductive pattern of the second conductive portion 322 may vary from a thin line shape that is the same on one side and the other side of the split portion 411c as a center to a rectangular plane shape, a triangular plane shape, and/or the like. Detailed examples of the conductive pattern of the second conductive portion 322 will be described with reference to FIGS. 16A to 16I.

Referring to FIG. 9, a portion (e.g., the first portion 411a) of the side surface member 410 may be used as a metal antenna radiator, and another portion (e.g., the second portion 411b) of the side surface member 410 may not be used as a metal antenna radiator. Correspondingly, the conductive portion 320 provided at a position corresponding to the first portion 411a of the side surface member 410 and the conductive portion 320 provided at a position corresponding to the second portion 411b may have different shapes and sizes. For example, the first conductive portion 321 may include a (1-1)^{th} conductive portion 321a disposed at a position corresponding to an antenna area of the first side surface portion 411, and a (1-2)^{th} conductive portion 321b disposed at a position corresponding to a non-antenna area of the first side surface portion 411. In addition, the second conductive portion 322 may include a (2-1)^{th} conductive portion 322a extending from an end of the (1-1)^{th} conductive portion 321a toward the side surface member 410 and a (2-2)^{th} conductive portion 322b extending from an end of the (1-2)^{th} conductive portion 321b toward the side surface member.

According to an embodiment, the conductive portion 320 may further include a third conductive portion 323 extending from the first conductive portion 321 at a position that does not correspond to the split portion 411c toward the side surface member 410. The (2-1)^{th} conductive portion 322a may transfer static electricity ESD to the (1-1)^{th} conductive portion 321a, the (2-2)^{th} conductive portion 322b may transfer static electricity ESD to the (1-2)^{th} conductive portion (321b), and the third conductive portion 323 may serve to discharge static electricity ESD to the side surface member 410. The third conductive portion 323 may extend to be oriented in the same direction as the second conductive portion 322 and to have the same width. The third conductive portion 323 may have a wider width than the second conductive portion 322. In the embodiments of FIGS. 8 and 9, the third conductive portion 323 is illustrated as being provided at a position corresponding to an area not utilized as an antenna radiator, but is not necessarily limited thereto. The third conductive portion 323 may also be provided at a position corresponding to an area used as an antenna radiator.

FIG. 10 is a view illustrating a conductive portion of a side surface member and a protection member adjacent thereto, according to an embodiment of the disclosure.

FIG. 10 illustrates a state in which a protection member 300 and a support member 400 are disposed with their upper and lower sides reversed on one side (left) and the other side (right) of the axis C-C'.

According to an embodiment, the support member 400 may include a side surface member 410, a bracket assembly 420, and a resin portion 430. The side surface member 410 may define the appearance of the support member 400, the bracket assembly 420 may have at least one component disposed thereon or may support at least one component of an electronic device (e.g., the electronic device 10 in FIG. 5), and the resin portion 430 may be disposed between the side surface member 410 and the bracket assembly 420. According to an embodiment, the side surface member 410 may be used as a metal antenna in a state of being insulated from other components of the electronic device (e.g., the electronic device 10 of FIG. 5) by the resin portion 430 and may radiate signals (e.g., RF signals) having a predetermined frequency.

Referring to FIG. 10, the side surface member 410 may include a first side surface portion 411 (e.g., the (1-1)^{th} side surface portion 111 in FIG. 1) extending in parallel to a folding axis (e.g., the folding axis A in FIG. 1), a second side surface portion 412 (e.g., the (1-2)^{th} side surface portion 112 in FIG. 1) extending from a first end of the first side surface portion 411 and perpendicular to the folding axis A, and a third side surface portion 413 (e.g., the (1-3)^{th} side surface portion 113 in FIG. 1) extending from a second end of the first side surface portion 411 and perpendicular to the folding axis A. Although not illustrated in FIG. 10, the side surface member 410 may include a fourth side surface portion (e.g., the (1-4)^{th} side surface portion 114 in FIG. 1) extending between the second side surface portion 412 and the third side surface portion 413 and extending in parallel to the folding axis.

The side surface member 410 may define the side surface of a housing and may include a first portion 411a made of a conductive material, a second portion 411b made of a conductive material and electrically separated from the first portion 411a, and a split portion 411c made of an insulating material between the first portion 411a and the second portion 411b. According to an embodiment, the first side surface portion 411 may be divided into a plurality of pieces along the length direction of the electronic device (e.g., the electronic device 10 in FIG. 5) (the Y-axis direction), and may include, for example, first side surface portions 411 indicated by reference numerals 411-1, 411-2, and 411-3. According to an embodiment, the first side surface portions 411 indicated by reference numerals 411-1 and 411-3 may include a conductive material corresponding to the first portion 411a and may be used as antenna radiators, or the first side surface portion 411 indicated by 411-2 may include a conductive material corresponding to the second portion 411b but may not be used as an antenna radiator.

Correspondingly, the protection member 300 may include peripheral portions 311, 312, and 313 corresponding to the first side surface portion 411, the second side surface portion 412, and the third side surface portion 413. For example, when the side surface member 410 includes the fourth side surface portion, the protection member 300 may further include a peripheral portion corresponding to the fourth side surface portion. A conductive portion 320 may be disposed on the peripheral portion 311 corresponding to the first side surface portion 411 among the peripheral portions 311, 312, and 313 of the protection member 300. The conductive portion 320 may be at least partially surrounded by the non-conductive portion 310. A plurality of split portions 412c and 413c are illustrated in the second side surface portion 412 and the third side surface portion 413, respectively, but the second side surface portion 412 and the third side surface portion 413 may not be provided with the conductive portion 320 since a separation space that makes the display 200 movable is not provided therein.

The conductive portion 320 may include a first conductive portion 321 extending in parallel to the length direction of an electronic device (e.g., the electronic device 10 in FIG. 5) (the Y-axis direction) and a second conductive portion 322 extending from an end of the first conductive portion 321 corresponding to a split portion toward the side surface member 410.

The first conductive portion 321 may include (1-1)^{th} conductive portions 321 disposed at positions corresponding to first side surface portions 411 indicated by reference numerals 411-1 and 411-3 and a (1-2)^{th} conductive portion 321a disposed at a position corresponding to a non-antenna area of the first side surface portion 411 indicated by reference numeral 411-2. In addition, the second conductive portion 322 may include a (2-1)^{th} conductive portion 322a extending from an end of the (1-1)^{th} conductive portion 321a toward the side surface member 410 and a (2-2)^{th} conductive portion 322b extending from an end of the (1-2)^{th} conductive portion 321b toward the side surface member 410.

According to an embodiment, the width w2 of the first conductive portion 321 may be a half or less of the width w1 of the protection member 300. In this way, it is possible to downsize the protection member 300 and to reduce and/or prevent its effect on the radiation performance of the metal antenna. For example, the first conductive portion 321 may have a width w2 of 0.1 to 1.5 mm. For example, the first conductive portion 321 may be a conductive pattern having a width w2 of 0.5 mm.

According to an embodiment, when a portion of the first side surface portion 411 is used as an antenna or is used for tuning radiation deterioration of an antenna, the widths of the (2-1)^{th} conductive portion 322a and the (2-2)^{th} conductive portion 322b may be configured to be different from each other. According to an embodiment, when the first side surface portion 411 indicated by reference numeral 411-1 is used as an antenna and the first side surface portion 411 indicated by reference numeral 411-2 is not used as an antenna, the width w4 of the (2-2)^{th} conductive portion 322b may be greater than the width w3 of the (2-1)^{th} conductive portion 322a. Since the (2-2)^{th} conductive portion 322b adjacent to the first side surface portion 411 that is not used as an antenna has nothing to do with the radiation performance of the electronic device, it is possible to induce the flow of static electricity ESD more stably by increasing the width w4 of the conductive pattern. In contrast, since the (2-1)^{th} conductive portion 322a adjacent to the first side surface portion 411 used as an antenna affects the radiation performance of the electronic device, it is possible to make the electronic device (e.g., the electronic device 10 in FIG. 5) exhibit more stable radiation performance by decreasing the width w3 of the conductive pattern. Since the radiation performance is deteriorated as the width w3 of a conductive pattern increases, the (2-1)^{th} conductive portion 322a adjacent to the first side surface portion 411 used as an antenna may be a conductive pattern having a width as small as possible in a range maximally satisfying performance for discharging static electricity ESD.

Referring to FIG. 10, the side surface member 410 may include at least a partial anodized area that has been subjected anodizing treatment. In order to make the inner/outer appearance design of a housing of an electronic device (e.g., the electronic device 10 of FIG. 5) beautiful, for example, the housing may be colored. To this end, the side surface member 410 of the electronic device may at least partially include an anodized area that has been subjected to anodizing treatment. In this regard, according to an embodiment of the disclosure, a non-anodized area AO ' (or may be referred to as an "anodizing open area") that has not been subjected to anodizing treatment at a position corresponding to the second conductive portion 322 and/or the third conductive portion 323 of the side surface member 410. Here, the non-anodized area AO may include not only a portion that has not been subjected to anodizing treatment even once, but also an example in which a portion has been subjected to anodizing treatment one or more times and then subjected to be delaminated to make the non-anodized area AO. By providing the non-anodized area AO at a position corresponding to the second conductive portion 322 and/or the third conductive portion 323 of the side surface member 410, discharge of static electricity ESD through the conductive portion 320 of the protection member 300 may be implemented.

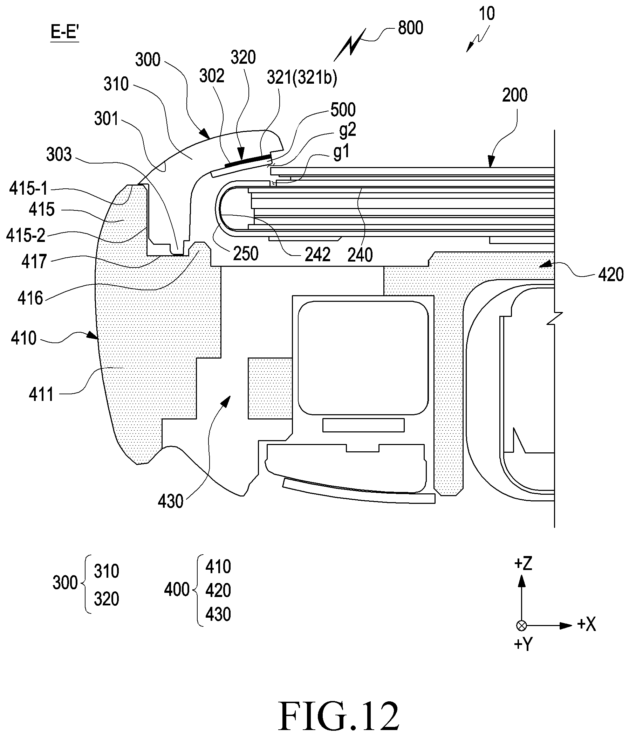

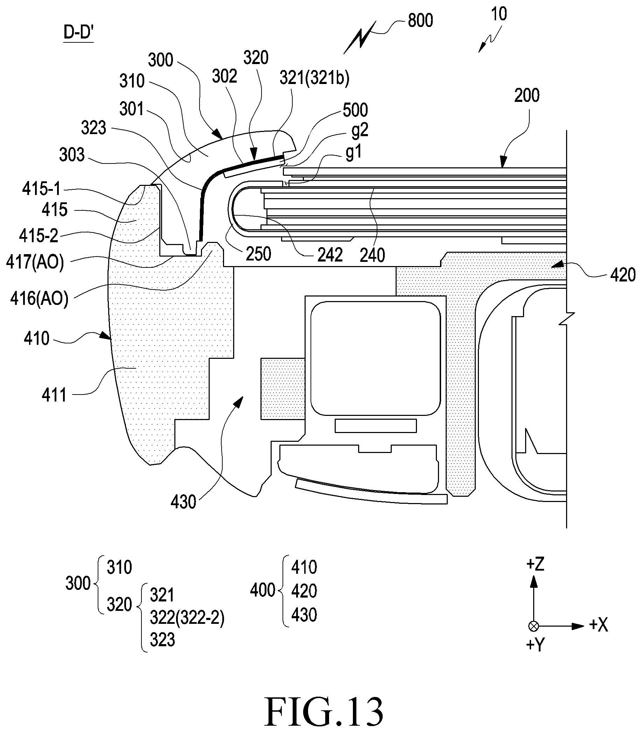

FIG. 11 is a cross-sectional view of an electronic device including a protection member corresponding to line D-D' of FIG. 10, according to an embodiment of the disclosure. FIG. 12 is a cross-sectional view of an electronic device including a protection member corresponding to the line E-E' of FIG. 10, according to an embodiment of the disclosure. FIG. 13 is a cross-sectional view of an electronic device including a protection member corresponding to line F-F' of FIG. 10, according to an embodiment of the disclosure.

FIGS. 11, 12, and 13 may respectively illustrate cross-sections of the electronic device 10 corresponding to lines D-D', E-E', and F-F' of FIG. 10. The conductive portion 320 of the disclosure will be more clearly understood through the illustrations of FIGS. 11, 12, and 13. In describing the embodiments of FIGS. 11, 12, and 13, detailed descriptions overlapping those described above with reference to FIG. 5 will be omitted.

In the embodiment illustrated in FIG. 11, the conductive portion 320 may be provided such that the first conductive portion 321 and the second conductive portion 322 overlap a substantial area of the inner surface 302 of the protection member 300. The conductive portion 320 may include a curved portion corresponding to the shape of the inner surface 302 of the protection member 300. According to an embodiment, the second conductive portion 322 may extend toward the side surface member 410 to be directly connected to the side surface member 410, but electrical connection with the side surface member 410 may be implemented without being directly connected to the side surface member 410 if the distance is sufficient to induce static electricity 800 toward the side surface member 410 side. The first conductive portion 321 may substantially face the front surface of the display 200, and the second conductive portion 322 may face the side surface of the display 200. When static electricity 800 is introduced into the electronic device, the second conductive portion 322 may prevent static electricity 800 from being introduced into the display 200 through the first separation space g1 and may guide the static electricity 800 in the length direction of the electronic device 10 (the Y-axis direction) to be transferred to the first conductive portion 321.

In the embodiment illustrated in FIG. 12, the conductive portion 320 is illustrated as including only a narrow first conductive portion 321. The first conductive portion 321 may guide the static electricity 800 to move in the length direction of the electronic device 10 (the Y-axis direction).

In the embodiment illustrated in FIG. 13, the conductive portion 320 may be provided such that the first conductive portion 321 and the third conductive portion 323 overlap a substantial area of the inner surface 302 of the protection member 300. The conductive portion 320 may include a curved portion corresponding to the shape of the inner surface 302 of the protection member 300. According to an embodiment, the third conductive portion 323 may extend toward the side surface member 410 to be directly connected to the side surface member 410, but electrical connection with the side surface member 410 may be implemented without being directly connected to the side surface member 410 if the distance is sufficient to induce static electricity 800 toward the side surface member 410 side. The first conductive portion 321 may substantially face the front surface of the display 200, and the third conductive portion 323 may face the side surface of the display 200. When the static electricity 800 is introduced into the electronic device, the static electricity 800 may be guided by the third conductive portion 323 to be transferred to the side surface member 410 and discharged without being introduced into the display 200 side through the first separation space g1. As illustrated in the embodiment of FIG. 13, according to an embodiment, at least one portion of the side surface member 410 (e.g., a protrusion 416 and a seating portion 417) may be provided as a non-anodized area to correspond to the third conductive portion 323.

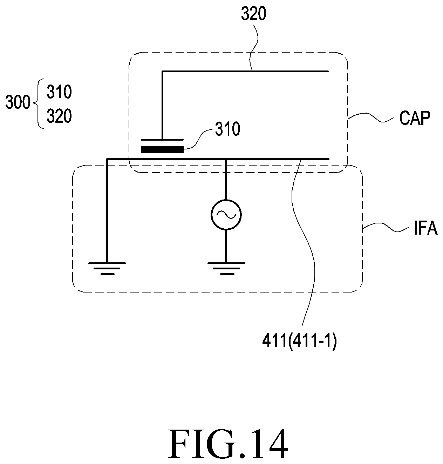

FIG. 14 is a view illustrating an equivalent circuit for a side surface member and a protection member according to an embodiment of the disclosure.

According to an embodiment, as described above with reference to FIG. 10, when the first side surface portions 411 indicated by reference numerals 411-1 and 411-3 are used as antennas, the conductive portion 320 providing a discharge path at a position corresponding to the first side surface portions may be used as an antenna frequency tuning mechanism. For example, referring to FIG. 14, the first side surface portion 411 indicated by reference numeral 411-1 and the conductive portion 320 may be equivalent to a circuit in which a capacitance (CAP) antenna is added to an inverted F antenna (IFA).

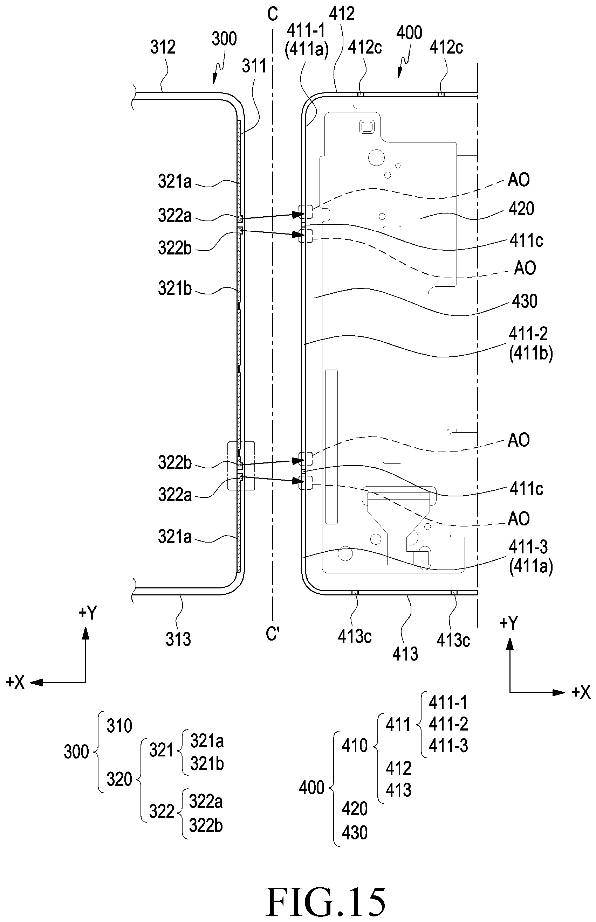

FIG. 15 is a view illustrating a conductive portion of a side surface member and a protection member adjacent thereto, according to an embodiment of the disclosure. In describing the embodiment of FIG. 15, a description overlapping that made with reference to FIG. 10 may be omitted.

FIGS. 10 and 15 may illustrate an embodiment in which the second conductive portion 322 provided adjacent to the split portion 411c of the side surface member 410 is not used as a discharge path and an embodiment in which the second conductive portion is used as a discharge path, respectively.

The embodiment illustrated in FIG. 10 may be an embodiment that additionally includes a conductive portion 323 of FIG. 3 in addition to the second conductive portion 322. Here, the second conductive portion 322 may serve as a bridge to guide static electricity ESD to the first conductive portion 321 when the static electricity ESD is introduced into the electronic device (e.g., the electronic device 10 in FIG. 5), and the third conductive portion 323 may provide a path for discharging, to the side surface member 410, static electricity ESD transferred through the first conductive portion 321.

Unlike the embodiment illustrated in FIG. 10, the embodiment illustrated in FIG. 15 may not additionally include the third conductive portion 323. Here, the second conductive portion 322 may provide a path that discharges, to the side surface member 410, static electricity ESD directly introduced through the split portion 411c or transferred via the first conductive portion 321, rather than serving as a bridge to guide ESD to the first conductive portion 321 when static electricity ESD is introduced into the electronic device (e.g., the electronic device 10 in FIG. 5). According to the embodiment illustrated in FIG. 15, the width of the second conductive portion 322 may be greater than that of the second conductive portion 322 according to the embodiment illustrated in FIG. 10. In addition, according to the embodiment illustrated in FIG. 15, at least a portion of the side surface member 410 may be provided as a non-anodized area AO to correspond to the position of the second conductive portion 322.

FIGS. 16A to 16I are views illustrating various embodiments of conductive portions of the disclosure.

With reference to FIGS. 16A to 16I, various embodiments of a conductive portion 320a at a position corresponding to a metal antenna and a conductive portion 320b at a position not corresponding to a metal antenna may be discussed. It is noted that although the third conductive portion (e.g., the third conductive portion 323 in FIG. 10) are omitted in FIGS. 16A to 16I, the third conductive portion may be added in some embodiments.

As described above in the embodiment of FIG. 9, a portion (e.g., the first portion 411a) of the side surface member (e.g., the side surface member 410 in FIG. 10) may be used as an antenna radiator, and the other portion (e.g., the second portion 411b) of the side surface member 410 may not be used as an antenna radiator. Correspondingly, the conductive portion 320a provided at a position corresponding to a metal antenna (e.g., the first portion 411a) of the side surface member 410 and the conductive portion 320a provided at a position corresponding to a non-antenna area(e.g., the second portion 411b) may have different shapes and sizes. The conductive portion 320a provided at a position corresponding to an antenna (e.g., the first portion 411a) may include a (1-1)^{th} conductive portion 321a and a (2-1)^{th} conductive portion 322a extending from an end of the (1-1)^{th} conductive portion 321a toward the side surface member 410. The conductive portion 320b provided at a position corresponding to a non-antenna area(e.g., the second portion 411b) may include a (1-2)^{th} conductive portion 321b and a (2-2)^{th} conductive portion 322b extending from an end of the (1-2)^{th} conductive portion 321b toward the side surface member.

FIGS. 16A to 16I illustrate that the non-conductive portion 310 of the protection member 300 includes a first peripheral portion 311 and a second peripheral portion 312 as peripheral portions corresponding to the side surface member (e.g., the side surface member 410 in FIG. 10). The (1-1)th conductive portion 321a and the (1-2)^{th} conductive portion 321b may each extend long along a peripheral portion (e.g., the first peripheral portion 311) of the protection member 300. According to an embodiment, the (1-1)^{th} conductive portion 321a and the (1-2)^{th} conductive portion 321b may be disposed on a straight line. The (2-1)^{th} conductive portion 322a and the (2-2)^{th} conductive portion 322b may extend in one direction (e.g., toward the side surface member 410) from one ends of the (1-1)^{th} conductive portion 321a and (1-2)^{th} conductive portion 321b, respectively. According to an embodiment, the (2-1)^{th} conductive portion 322a and the (2-2)^{th} conductive portion 322b may extend in one direction and may have substantially the same length as each other. However, the shape and width of each of the (2-1)^{th} conductive portion 322a and the (2-2)^{th} conductive portion 322b may be variously configured from embodiment to embodiment.

In the embodiment illustrated in FIG. 16A, a first peripheral portion 311 adjacent to the second peripheral portion 312 may correspond to an antenna area. According to an embodiment, the shapes and widths of the (2-1)^{th} conductive portion 322a and the (2-2)^{th} conductive portion 322b may be the same as each other. In the embodiment of FIG. 16A, a conductive portion 320a provided at a position corresponding to a metal antenna (e.g., the first portion 411a) and a conductive portion 320b provided at a position corresponding to a non-antenna area(e.g., the second portion 411b) may be both configured as band-shaped conductive patterns.

In the embodiment illustrated in FIG. 16B, the first peripheral portion 311 adjacent to the second peripheral portion 312 may correspond to an antenna area. According to an embodiment, the shapes and widths of the (2-1)^{th} conductive portion 322a and the (2-2)^{th} conductive portion 322b may be the same as each other, but the (2-1)^{th} conductive portion 322a and the (2-2)^{th} conductive portion 322b may have widths greater than those of the (2-1)^{th} conductive portion 322a and the (2-2)^{th} conductive portion 322b illustrated in FIG. 16A. For example, the embodiment of FIG. 16A may have a structure that is capable of discharging static electricity ESD when a third conductive portion (e.g., the third conductive portion 323 of FIG. 10) is added to an arbitrary position on the first peripheral portion 311. Unlike this, FIG. 16B may have a structure that is capable of discharging static electricity ESD via the (2-1)^{th} conductive portion 322a and the (2-2)^{th} conductive portion 322b.

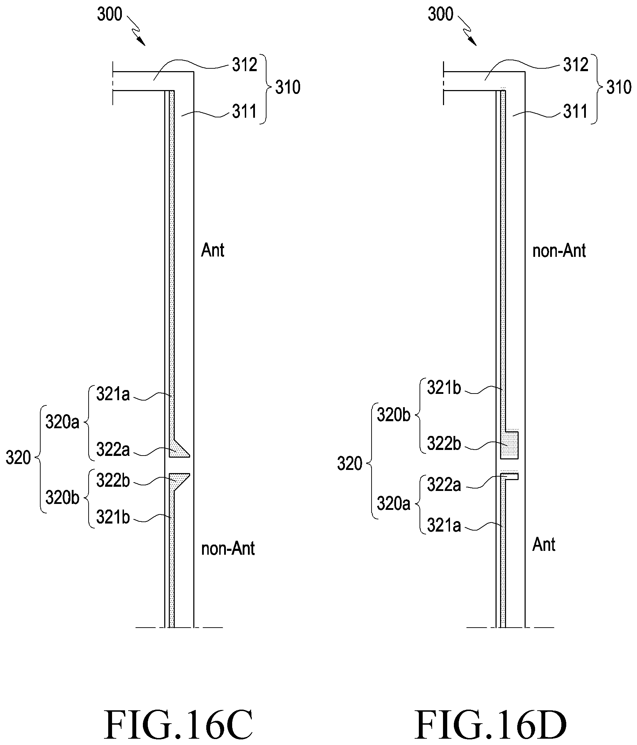

In the embodiment illustrated in FIG. 16C, the first peripheral portion 311 adjacent to the second peripheral portion 312 may correspond to an antenna area. According to an embodiment, the shapes and widths of the (2-1)^{th} conductive portion 322a and the (2-2)^{th} conductive portion 322b may be the same as each other. In the embodiment illustrated in FIG. 16C, the (2-1)^{th} conductive portion 322a and the (2-2)^{th} conductive portion 322b may have a triangular shape. According to an embodiment, the triangular shape is a right triangle, and sides other than the hypotenuse may be located on the conductive portions 320a and 320b, respectively.

In the embodiment illustrated in FIG. 16D, the first peripheral portion 311 adjacent to the second peripheral portion 312 may correspond to an antenna area. According to an embodiment, the shapes and widths of the (2-1)^{th} conductive portion 322a and the (2-2)^{th} conductive portion 322b in this case may be different from each other. In the embodiment illustrated in FIG. 16D, the width of the (2-1)^{th} conductive portion 322a may be substantially the same as that of the (1-1)^{th} conductive portion 321a. The width of the (2-2)^{th} conductive portion 322b may be greater than those of the (1-2)^{th} conductive portion 321b and the (2-1)^{th} conductive portion 322a. As described above in the embodiment of FIG. 10, since the conductive portion 320b at a position corresponding to a non-antenna area may have little effect on antenna radiation performance, the width of the (2-2)^{th} conductive portion 322b may be increased to provide a structure advantageous for electrostatic discharge.

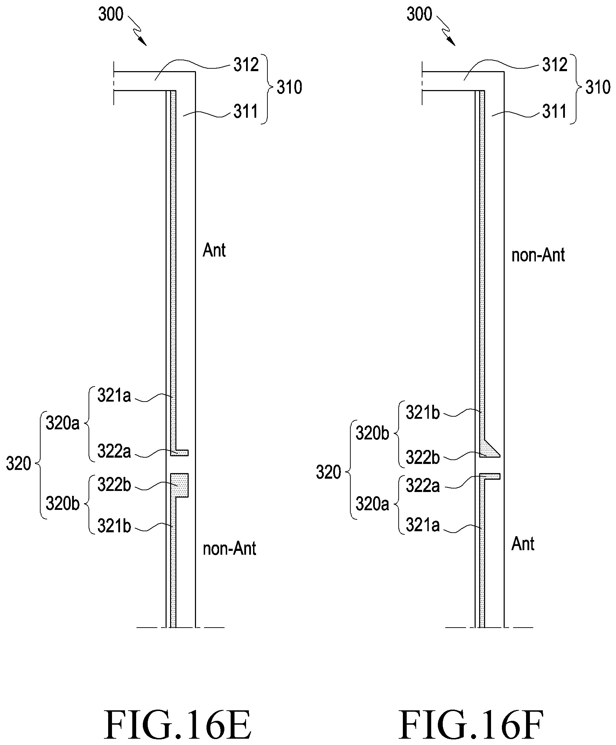

In the embodiment illustrated in FIG. 16E, the first peripheral portion 311 adjacent to the second peripheral portion 312 may correspond to a non-antenna area. In addition, the first peripheral portion 311 spaced apart from the second peripheral portion 312 may correspond to an antenna area. In the embodiment illustrated in FIG. 16E, the (2-2)^{th} conductive portion 322b having a relatively great width may be disposed closer to the second peripheral portion 312 than the (2-1)^{th} conductive portion 322a having a relatively small width.

In the embodiment illustrated in FIG. 16F, the first peripheral portion 311 adjacent to the second peripheral portion 312 may correspond to an antenna area. According to an embodiment, the shapes and widths of the (2-1)^{th} conductive portion 322a and the (2-2)^{th} conductive portion 322b in this case may be different from each other. In the embodiment illustrated in FIG. 16F, the width of the (2-1)^{th} conductive portion 322a may be substantially the same as that of the (1-1)^{th} conductive portion 321a. The (2-2)^{nd} conductive portion 322b may have a right triangle shape in which sides other than the hypotenuse are located on the conductive portion 320b.

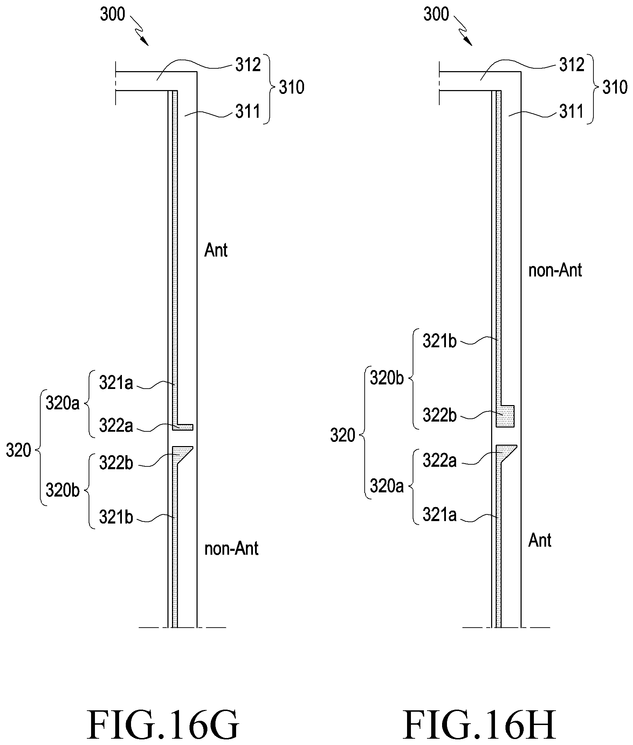

In the embodiment illustrated in FIG. 16E, the first peripheral portion 311 adjacent to the second peripheral portion 312 may correspond to a non-antenna area. In addition, the first peripheral portion 311 spaced apart from the second peripheral portion 312 may correspond to an antenna area. In the embodiment illustrated in FIG. 16G, the (2-2)^{th} conductive portion 322b having a right triangle shape may be disposed closer to the second peripheral portion 312 than the (2-1)^{th} conductive portion 322a having a band shape.

In the embodiment illustrated in FIG. 16H, the first peripheral portion 311 adjacent to the second peripheral portion 312 may correspond to an antenna area. According to an embodiment, the shapes and widths of the (2-1)^{th} conductive portion 322a and the (2-2)^{th} conductive portion 322b in this case may be different from each other. In the embodiment illustrated in FIG. 16H, the (2-1)^{th} conductive portion 322a may have the shape of a right triangle in which sides other than the hypotenuse are located on the conductive portion 320b, and the (2-2)^{th} conductive portion 322b may have a quadrangular shape. According to an embodiment, the width of the (2-2)^{th} conductive portion 322b may be greater than the lengths of the other side(s) of the (2-1)^{th} conductive portion 322a except for the hypotenuse.

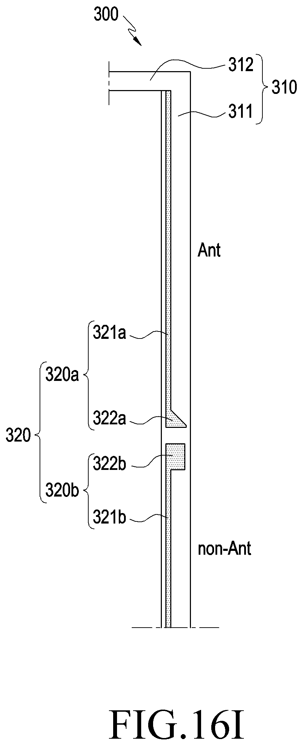

In the embodiment illustrated in FIG. 16I, the first peripheral portion 311 adjacent to the second peripheral portion 312 may correspond to a non-antenna area. In addition, the first peripheral portion 311 spaced apart from the second peripheral portion 312 may correspond to an antenna area. In the embodiment illustrated in FIG. 16I, the (2-2)th conductive portion 322b having a quadrangular shape may be disposed closer to the second peripheral portion 312 than the (2-1)^{th} conductive portion 322a having a right triangle shape.

An electronic device according to various embodiments of the disclosure have advantages in that the electronic device is capable of including a protection member that provides an effective electrostatic discharge path even when the electronic device is miniaturized and that radiation performance of a metal antenna disposed around the protection member is not deteriorated.

According to an embodiment of the disclosure, it is possible to provide an electronic device 10. The electronic device 10 may include a housing 100 including a first housing 101 and a second housing 102 and configured to be foldable around a folding axis A, and a flexible display 200. The housing may include a protection member 300 having an outer surface 301 facing outside of the electronic device and an inner surface 302 facing at least a portion of the flexible display, wherein the protection member includes a non-conductive portion 310 and a conductive portion 320 disposed on the inner surface 302, and a side surface member 410 including a first portion 410a defining a side surface of the housing and made of a conductive material, a second portion 410b made of a conductive material and electrically separated from the first portion, and a split portion 411c provided between the first portion and the second portion and made of an insulating material. The conductive portion 320 may include a first conductive portion 321 extending in parallel to a length direction of the electronic device, and a second conductive portion 322 extending from an end of the first conductive portion 321 at a position corresponding to the split portion toward the side surface member. The split portion 411c may be provided to use a portion of the side surface member 410 as an antenna. Correspondingly, the conductive portion 320 may also be separated into two or more conductive portions 320 rather than integrally extending in the length direction of the electronic device. A position of a separation or gap between ends of the first conductive portion 321 of the conductive portion 320 extending in parallel to the length direction of the electronic device may correspond to the split portion 411c. The electronic device may include a protection member having a smaller area so that there are fewer restrictions on reducing the width for the electronic device and which may reduce a deterioration effect on an antenna performance. The split portion 411c may be provided to use a portion of the side surface member 410 as an antenna. The first conductive portion 321 which extends in parallel to the length direction of the electronic device may guide static electricity ESD in the length direction of the protection member 300 while the second conductive portion 322 extending toward the side surface member 410 may discharge static electricity ESD toward the side surface member 410. Further, since the protection member 300 includes the second conductive portion 322 extending from an end of the first conductive portion 321 toward the side surface member 410, even when static electricity ESD is introduced into the position corresponding to the split portion 411c, the static electricity ESD may be discharged toward the side surface member 410 without being induced toward the flexible display 200. Further, the static electricity ESD introduced into the position corresponding to the split portion 411c may be captured by the second conductive portion 322 when passing through the periphery of the second conductive portion 322 and may flow into the first conductive portion 321. Thus, the second conductive portion 322 may serve as a bridge to transfer static electricity ESD to the first conductive portion 321.

The second conductive portion extends in a direction orthogonal to the length direction of the electronic device. Thus, ESD protection of the display may be improved since the first conductive portion 321 extending in parallel to the length direction of the electronic device may guide static electricity ESD in the length direction of the protection member 300, and the second conductive portion 322 extending toward the side surface member 410 may discharge static electricity ESD toward the side surface member 410.

According to an embodiment, the first conductive portion and the second conductive portion may be provided on opposite sides of the split portion, respectively. Thus, the first conductive portion 321 and the second conductive portion 322 disposed on one side of the split portion 411c and the first conductive portion 321 and the second conductive portion 322 disposed on the other side may induce, in opposite directions, static electricity ESD introduced through the split portion 411c.

According to an embodiment, the conductive portion may be configured with a conductive pattern. The conductive pattern of the second conductive portion 322 may be freely fabricated to have various shapes and sizes in consideration of the charge amount of static electricity ESD introduced into the split portion 411c and/or the radiation performance of the metal antenna according to the use of the side surface member 410 as a metal antenna. In examples, the conductive pattern of the second conductive portion 322 may vary from a thin line shape that is the same on one side and the other side of the split portion 411c as a center to a rectangular plane shape, a triangular plane shape, and/or the like.

According to an embodiment, the first conductive portion may have a width w2 that is a half or less of the width w1 of the protection member. In this way, it is possible to downsize the protection member 300 and/or to reduce or prevent its effect on the radiation performance when used as a metal antenna.

According to an embodiment, the first conductive portion may have a width w2 of 0.1 mm to 1.5 mm, preferably 0.3 mm to 1.2 mm, more preferably 0.5 mm to 1 mm.

According to an embodiment, the side surface member 410 may include a first side surface portion 411 (e.g., the first side surface portions 111 and 121 in FIG. 1) extending in parallel to the folding axis, a second side surface portion (e.g., the second side surface portion 112 and 122 in FIG. 1) extending from a first end of the first side surface portion and perpendicular to the folding axis, a third side surface portion (e.g., the third side surface portions 113 and 123 in FIG. 1) extending from a second end of the first side surface portion and perpendicular to the folding axis, and a fourth side surface portion (e.g., the fourth side surface portions 114 and 124 in FIG. 1) extending between the second side surface portion and the third side surface portion and extending parallel to the folding axis, and the protection member is disposed along a side surface member that defines the first side surface portion, the second side surface portion, the third side surface portion, and the fourth side surface portion of the housing.

According to an embodiment, the conductive portion of the protection member is provided at a position corresponding to the first side surface portion of the side surface member.

According to an embodiment, the first conductive portion 321 may include a (1-1)^{th} conductive portion 321a corresponding to an antenna area of the first side surface portion, and a (1-2)^{th} conductive portion 321b corresponding to a non-antenna area of the first side surface portion, and the second conductive portion 322 may include a (2-1)^{th} conductive portion 322a extending from an end of the (1-1)^{th} conductive portion 321a and a (2-2)^{th} conductive portion 322b extending from an end of the (1-2)^{th} conductive portion 321b. Thus, when the side surface member 410 is used as an antenna radiator by reducing the width of the first conductive portion 321 provided along the length direction of the protection member 300, it is possible to secure ESD discharge performance through the second conductive portion 322 provided at the position corresponding to the split portion 411c while minimizing the effect on the radiation performance of the antenna.

According to an embodiment, the (2-2)^{th} conductive portion 322b may have a width w4 is wider than the width w3 of the (2-1)^{th} conductive portion 322a. Since the (2-2)^{th} conductive portion 322b adjacent to the first side surface portion 411 that is not used as an antenna has nothing to do with the radiation performance of the electronic device, it is possible to induce the flow of static electricity ESD more stably by increasing the width w4 of the (2-2)^{th} conductive portion 322b. In contrast, since the (2-1)^{th} conductive portion 322a adjacent to the first side surface portion 411 used as an antenna affects the radiation performance of the electronic device, it is possible to make the electronic device exhibit more stable radiation performance by decreasing the width w3 of the (2-1)^{th} conductive portion 322a. Since the radiation performance is deteriorated as the width w3 of a (2-1)^{th} conductive portion 322a increases, the (2-1)^{th} conductive portion 322a adjacent to the first side surface portion 411 used as an antenna may be a conductive portion having a width as small as possible in a range maximally satisfying performance for discharging static electricity ESD.

According to an embodiment, the second conductive portion may extend toward the side surface member and is directly connected to the side surface member, or may extend toward the side surface member so that static electricity is induced toward the side surface member. Thus, when static electricity is introduced into the electronic device, the second conductive portion 322 may efficiently prevent static electricity from flowing into the display 200 and may efficiently guide the static electricity 800 in the length direction of the electronic device 10 (the Y-axis direction) to be transferred to the first conductive portion 321 and toward the side surface member 410 due to reduced distance.

According to an embodiment, the first conductive portion may be disposed on an inner surface of the protection member at a position facing a front surface of the flexible display, and the second conductive portion may extend from the first conductive portion and may be disposed on the inner surface of the protection member at a position facing a side surface of the flexible display. This orientation of the conductive members may prevent ESD to be transferred to the display to protect the display from more than one side. Thus, when static electricity is introduced into the electronic device, the second conductive portion 322 may prevent static electricity 800 from being introduced into the display 200 and may guide the static electricity 800 in the length direction of the electronic device 10 to be transferred to the first conductive portion 321.

According to an embodiment, the electronic device may further include a non-conductive member 500 disposed on an inner surface of the protection member to be spaced apart from the flexible display by a predetermined distance at a position at least partially overlapping the conductive portion. The non-conductive member 500 may block foreign substances from entering the display 200 through a space between the protection member 300 and the display 200. The non-conductive member 500 may prevent static electricity ESD from flowing on a path toward the display 200 through the conductive portion 320 of the protection member 300 and may guide the static electricity ESD to move toward the protection member 300.

According to an embodiment, the conductive portion 320 may include a third conductive portion 323 extending toward the side surface member from the first conductive portion 321b at a position that does not correspond to the split portion. The third conductive portion 323 may serve to discharge static electricity ESD to the side surface member 410. The third conductive portion 323 may extend to be oriented in the same direction as the second conductive portion 322 and to have the same width. The third conductive portion 323 may have a wider width than the second conductive portion 322.

According to an embodiment, the side surface member 410 may include an anodized area that has been at least partially subjected to anodizing treatment, and a position of the side surface member 410 corresponding to the second conductive portion 322 or the third conductive portion 323 may include a non-anodized area that has not been subjected to anodizing treatment. By providing the non-anodized area AO at a position corresponding to the second conductive portion 322 and/or the third conductive portion 323 of the side surface member 410, discharge of static electricity ESD through the conductive portion 320 of the protection member 300 may be implemented.

According to an embodiment of the disclosure, it is possible to provide a foldable electronic device. The foldable electronic device may include a housing 100 including a first housing 101 and a second housing 102 and configured to be foldable about a folding axis A, wherein the housing 100 includes a first side surface portion extending in parallel to the folding axis, a second side surface portion extending from a first end of the first side surface portion and perpendicular to the folding axis, a third side surface portion extending from the second end of the first side surface portion and perpendicular to the folding axis, and a fourth side surface portion extending between the second side surface portion and the third side surface portion and parallel to the folding axis, and a flexible display 200. The housing may include a protection member 300 having an outer surface 301 facing outside of the electronic device and an inner surface 302 facing at least a portion of the flexible display, wherein the protection member 300 includes a non-conductive portion 310 and a conductive portion 320 disposed on the inner surface 302, and a side surface member 410 defining the first side surface portion, the second side surface portion, the third side surface portion, and the fourth side surface portion of the housing, wherein the side surface member includes a first portion made of a conductive material, a second portion made of a conductive material and electrically separated from the first portion, and a split portion made of an insulating material between the first portion and the second portion. The conductive portion 320 may include a first conductive portion 321 extending along the first side surface portion in parallel to the length direction of the electronic device, and a second conductive portion 322 extending from an end of the first conductive portion at a position corresponding to the split portion toward the side surface member, whereby the conductive portion 320 is capable of discharging static electricity.

According to an embodiment, the first conductive portion 321 may include a (1-1)^{th} conductive portion 321a corresponding to an antenna area of the first side surface portion, and a (1-2)^{th} conductive portion 321b corresponding to a non-antenna area of the first side surface portion, and the second conductive portion 322 may include a (2-1)^{th} conductive portion 322a extending from an end of the (1-1)^{th} conductive portion 321a and a (2-2)^{th} conductive portion 322b extending from an end of the (1-2)^{th} conductive portion 321b.

According to an embodiment, the (2-2)^{th} conductive portion 322b may have a width w2 wider than the width w1 of the (2-1)^{th} conductive portion 322a.

According to an embodiment of the disclosure, it is possible to provide an electronic device 10. The electronic device 10 may include a housing 100 configured to be foldable, and a flexible display 200. The housing may include a protection member 300 including a non-conductive portion 310 and a conductive portion 320, and a side surface member 410 defining a side surface of the housing and at least partially made of a conductive material. The conductive portion 320 may include a first conductive portion 321 disposed on an inner surface 302 of the protection member and extending at least partially in parallel to a length direction of the electronic device, and a second conductive portion 322 connected to the first conductive portion and extending in a direction different from the direction in which the first conductive portion extends.

According to an embodiment, the side surface member may include a first portion made of a conductive material, a second portion made of a conductive material and electrically separated from the first portion, and a split portion made of an insulating material between the first portion and the second portion, and the second conductive portion may extend from an end of the first conductive portion at a position corresponding to the split portion toward the side surface member.

Although the disclosure has been described with reference to an embodiment as an example, it is to be understood that various embodiments are intended to be exemplary and not to limit the disclosure. It will be apparent to those skilled in the art that various changes can be made in form and detail without departing from the overall scope of the disclosure. For example, the shape of the protection member 300, the non-conductive portion 310, and/or the conductive portion 320 included therein may vary from embodiment and embodiment.

## Claims

1. An electronic device (10) comprising:
a housing (100) comprising a first housing (101) and a second housing (102) and configured to be foldable around a folding axis (A); and
a flexible display (200),
wherein the housing comprises:
a protection member (300) comprising an outer surface (301) facing outside of the electronic device and an inner surface (302) facing at least a portion of the flexible display (200), wherein the protection member (300) comprises a non-conductive portion (310) and a conductive portion (320) disposed on the inner surface (302); and
a side surface member (410) defining a side surface of the housing and comprising a first portion (411a), a second portion (411b) and a split portion (411c) each defining a part of the side surface, wherein the first portion (411a) is formed of a conductive material, the second portion (411b) is formed of a conductive material and electrically separated from the first portion, and the split portion (411c) is provided between the first portion and the second portion and formed of an insulating material,
wherein the conductive portion (320) comprises:
a first conductive portion (321) extending in parallel to a length direction of the electronic device, and
a second conductive portion (322),
**characterised in that** the second conductive portion (322) extends from an end of the first conductive portion (321) in a direction orthogonal to the length direction of the electronic device toward the side surface member (410) at a position corresponding to the split portion (411c).

2. The electronic device of claim 1, wherein the first conductive portion (321) is provided on opposite sides of the split portion (411c) and the second conductive portion (322) is provided on opposite sides of the split portion (411c).

3. The electronic device of one of claims 1 to 2, wherein the conductive portion (320) is formed as a conductive pattern.

4. The electronic device of one of claims 1 to 3, wherein the first conductive portion (321) has a width (w2) that is a half or less of a width (w1) of the protection member.

5. The electronic device of one of claims 1 to 4, wherein the first conductive portion has a width (w2) of 0.1 mm to 1.5 mm preferably 0.3 mm to 1.2 mm, more preferably 0.5 mm to 1 mm.

6. The electronic device of one of claims 1 to 5, wherein the side surface member (410) comprises a first side surface portion (411) extending in parallel to the folding axis, a second side surface portion (412) extending from a first end of the first side surface portion and perpendicular to the folding axis, a third side surface portion (413) extending from a second end of the first side surface portion and perpendicular to the folding axis, and a fourth side surface portion (414) extending between the second side surface portion and the third side surface portion and extending parallel to the folding axis, and
the protection member (300) is disposed along the side surface member (410), the side surface member (410) defining the first side surface portion, the second side surface portion, the third side surface portion, and the fourth side surface portion.

7. The electronic device of claim 6, wherein the conductive portion (320) of the protection member (300) is provided at a position corresponding to the first side surface portion (411) of the side surface member (410).

8. The electronic device of claim 6, wherein the first conductive portion (321) comprises a (1-1)^{th} conductive portion (321a) disposed at a position corresponding to an antenna area of the first side surface portion, and a (1-2)^{th} conductive portion (321b) disposed at a position corresponding to a non-antenna area of the first side surface portion, and
the second conductive portion (322) comprises a (2-1)^{th} conductive portion (322a) extending from an end of the (1-1)^{th} conductive portion (321a) toward the side surface member and a (2-2)^{th} conductive portion (322b) extending from an end of the (1-2)^{th} conductive portion (321b) toward the side surface member.

9. The electronic device of claim 8, wherein the (2-2)^{th} conductive portion (322b) has a width (w4) wider than a width (w3) of the (2-1)^{th} conductive portion (322a).

10. The electronic device of one of claims 1 to 9, wherein the second conductive portion (322) extends toward the side surface member (410) and is directly connected to the side surface member (410), or extends toward the side surface member (410) so that static electricity is induced toward the side surface member (410).

11. The electronic device of one of claims 1 to 10, wherein the first conductive portion (321) is disposed on an inner surface of the protection member (300) at a position facing a front surface of the flexible display (200), and
the second conductive portion (322) extends from the first conductive portion (321) and is disposed on the inner surface of the protection member (300) at a position facing a side surface of the flexible display (200).

12. The electronic device of one of claims 1 to 11, further comprising a non-conductive member (500) disposed on an inner surface of the protection member (300) to be spaced apart from the flexible display (200) by a specified distance at a position at least partially overlapping the conductive portion (320).

13. The electronic device of one of claims 1 to 12, wherein the conductive portion (320) comprises a third conductive portion (323) extending toward the side surface member (410) from the first conductive portion (321b) at a position that does not correspond to the split portion (411c).

14. The electronic device of claim 13, wherein the side surface member (410) comprises an anodized area that has been at least partially subjected to anodizing treatment, and a position of the side surface member (410) corresponding to the second conductive portion (322) or the third conductive portion (323) comprises a non-anodized area that has not been subjected to anodizing treatment.

## Patentansprüche

1. Elektronische Vorrichtung (10), umfassend:
ein Gehäuse (100), das ein erstes Gehäuse (101) und ein zweites Gehäuse (102) umfasst und konfiguriert ist, um um eine Faltachse (A) faltbar zu sein; und
eine flexible Anzeige (200),
wobei das Gehäuse umfasst:
ein Schutzelement (300), umfassend eine Außenfläche (301), die der Außenseite der elektronischen Vorrichtung zugewandt ist, und eine Innenfläche (302), die mindestens einem Abschnitt der flexiblen Anzeige (200) zugewandt ist, wobei das Schutzelement (300) einen nichtleitenden Abschnitt (310) und einen leitfähigen Abschnitt (320) umfasst, die auf der Innenfläche (302) angeordnet sind; und
ein Seitenflächenelement (410), das eine Seitenfläche des Gehäuses definiert und einen ersten Abschnitt (411a), einen zweiten Abschnitt (411b) und einen geteilten Abschnitt (411c) aufweist, die jeweils einen Teil der Seitenfläche definieren, wobei der erste Abschnitt (411a) aus einem leitfähigen Material ausgebildet ist, der zweite Abschnitt (411b) aus einem leitfähigen Material ausgebildet und elektrisch vom ersten Abschnitt getrennt ist und der geteilte Abschnitt (411c) zwischen dem ersten Abschnitt und dem zweiten Abschnitt vorgesehen ist und aus einem Isoliermaterial ausgebildet ist,
wobei der leitfähige Abschnitt (320) umfasst:
einen ersten leitfähigen Abschnitt (321), der sich parallel zu einer Längsrichtung der elektronischen Vorrichtung erstreckt, und
einen zweiten leitfähigen Abschnitt (322), **dadurch gekennzeichnet, dass** sich der zweite leitfähige Abschnitt (322) von einem Ende des ersten leitfähigen Abschnitts (321) in einer Richtung orthogonal zur Längsrichtung der elektronischen Vorrichtung in Richtung des Seitenflächenelements (410) an einer Position erstreckt, die dem geteilten Abschnitt (411c) entspricht.

2. Elektronische Vorrichtung nach Anspruch 1, wobei der erste leitfähige Abschnitt (321) auf gegenüberliegenden Seiten des geteilten Abschnitts (411c) vorgesehen ist und der zweite leitfähige Abschnitt (322) auf gegenüberliegenden Seiten des geteilten Abschnitts (411c) vorgesehen ist.

3. Elektronische Vorrichtung nach einem der Ansprüche 1 bis 2, wobei der leitfähige Abschnitt (320) als ein leitfähiges Muster ausgebildet ist.

4. Elektronische Vorrichtung nach einem der Ansprüche 1 bis 3, wobei der erste leitfähige Abschnitt (321) eine Breite (w2) aufweist, die die Hälfte oder weniger der Breite (w1) des Schutzelements beträgt.

5. Elektronische Vorrichtung nach einem der Ansprüche 1 bis 4, wobei der erste leitfähige Abschnitt eine Breite (w2) von 0,1 mm bis 1,5 mm, vorzugsweise von 0,3 mm bis 1,2 mm, noch bevorzugter von 0,5 mm bis 1 mm aufweist.

6. Elektronische Vorrichtung nach einem der Ansprüche 1 bis 5, wobei das Seitenflächenelement (410) einen ersten Seitenflächenabschnitt (411), der sich parallel zur Faltachse erstreckt, einen zweiten Seitenflächenabschnitt (412), der sich von einem ersten Ende des ersten Seitenflächenabschnitts und senkrecht zur Faltachse erstreckt, einen dritten Seitenflächenabschnitt (413), der sich von einem zweiten Ende des ersten Seitenflächenabschnitts und senkrecht zur Faltachse erstreckt, und einen vierten Seitenflächenabschnitt (414), der sich zwischen dem zweiten Seitenflächenabschnitt und dem dritten Seitenflächenabschnitt erstreckt und sich parallel zur Faltachse erstreckt, umfasst, und
das Schutzelement (300) entlang des Seitenflächenelements (410) angeordnet ist, das Seitenflächenelement (410) den ersten Seitenflächenabschnitt, den zweiten Seitenflächenabschnitt, den dritten Seitenflächenabschnitt und den vierten Seitenflächenabschnitt definiert.

7. Elektronische Vorrichtung nach Anspruch 6, wobei der leitfähige Abschnitt (320) des Schutzelements (300) an einer Position vorgesehen ist, die dem ersten Seitenflächenabschnitt (411) des Seitenflächenelements (410) entspricht.

8. Elektronische Vorrichtung nach Anspruch 6, wobei der erste leitfähige Abschnitt (321) einen (1-1)^{ten} leitfähigen Abschnitt (321a), der an einer Position angeordnet ist, die einem Antennenbereich des ersten Seitenflächenabschnitts entspricht, und einen (1-2)^{ten} leitfähigen Abschnitt (321b), der an einer Position angeordnet ist, die einem Nicht-Antennenbereich des ersten Seitenflächenabschnitts entspricht, umfasst, und
der zweite leitfähige Abschnitt (322) einen (2-1)^{ten} leitfähigen Abschnitt (322a), der sich von einem Ende des (1-1)^{ten} leitfähigen Abschnitts (321a) zu dem Seitenflächenelement hin erstreckt, und einen (2-)2)^{ten} leitfähigen Abschnitt (322b), der sich von einem Ende des (1-2)^{ten} leitfähigen Abschnitts (321b) in Richtung des Seitenflächenelements erstreckt, umfasst.

9. Elektronische Vorrichtung nach Anspruch 8, wobei der (2-2)^{te} leitfähige Abschnitt (322b) eine Breite (w4) aufweist, die größer ist als eine Breite (w3) des (2-1)^{ten} leitfähigen Abschnitts (322a).

10. Elektronische Vorrichtung nach einem der Ansprüche 1 bis 9, wobei sich der zweite leitfähige Abschnitt (322) in Richtung des Seitenflächenelements (410) erstreckt und direkt mit dem Seitenflächenelement (410) verbunden ist, oder sich in Richtung des Seitenflächenelements (410) erstreckt, so dass statische Elektrizität in Richtung des Seitenflächenelements (410) induziert wird.

11. Elektronische Vorrichtung nach einem der Ansprüche 1 bis 10, wobei der erste leitfähige Abschnitt (321) auf einer Innenfläche des Schutzelements (300) an einer Position angeordnet ist, die einer Vorderfläche der flexiblen Anzeige (200) zugewandt ist, und
der zweite leitfähige Abschnitt (322) sich von dem ersten leitfähigen Abschnitt (321) erstreckt und auf der Innenfläche des Schutzelements (300) an einer Position positioniert ist, die einer Seitenfläche der flexiblen Anzeige (200) zugewandt ist.

12. Elektronische Vorrichtung nach einem der Ansprüche 1 bis 11, ferner umfassend ein nichtleitendes Element (500), das auf einer Innenfläche des Schutzelements (300) so angeordnet ist, dass es von der flexiblen Anzeige (200) um einen bestimmten Abstand an einer Position beabstandet ist, die den leitfähigen Abschnitt (320) zumindest teilweise überlappt.

13. Elektronische Vorrichtung nach einem der Ansprüche 1 bis 12, wobei der leitfähige Abschnitt (320) einen dritten leitfähigen Abschnitt (323) umfasst, der sich von dem ersten leitfähigen Abschnitt (321b) an einer Position, die nicht dem geteilten Abschnitt (411c) entspricht, zu dem Seitenflächenelement (410) erstreckt.

14. Elektronische Vorrichtung nach Anspruch 13, wobei das Seitenflächenelement (410) einen anodisierten Bereich umfasst, der zumindest teilweise einer Anodisierungsbehandlung unterzogen wurde, und eine Position des Seitenflächenelements (410), die dem zweiten leitfähigen Abschnitt (322) oder dem dritten leitfähigen Abschnitt (323) entspricht, einen nicht anodisierten Bereich umfasst, der keiner Anodisierungsbehandlung unterzogen wurde.

## Revendications

1. Dispositif électronique (10), comprenant :
un boîtier (100) comprenant un premier boîtier (101) et un deuxième boîtier (102) et configuré pour être pliable autour d'un axe de pliage (A) ; et
un affichage flexible (200),
dans lequel le boîtier comprend :
un élément de protection (300) comprenant une surface extérieure (301) faisant face à l'extérieur du dispositif électronique et une surface intérieure (302) faisant face à au moins une partie de l'affichage flexible (200), dans lequel l'élément de protection (300) comprend une partie non conductrice (310) et une partie conductrice (320) disposée sur la surface intérieure (302) ; et
un élément de surface latérale (410) définissant une surface latérale du boîtier et comprenant une première partie (411a), une deuxième partie (411b) et une partie divisée (411c) définissant chacune une partie de la surface latérale, dans lequel la première partie (411a) est formée d'un matériau conducteur, la deuxième partie (411b) est formée d'un matériau conducteur et séparée électriquement de la première partie, et la partie divisée (411c) est prévue entre la première partie et la deuxième partie et formée d'un matériau isolateur.
dans lequel la partie conductrice (320) comprend :
une première partie conductrice (321) s'étendant parallèlement à une direction de longueur du dispositif électronique, et
une deuxième partie conductrice (322), **caractérisé en ce que** la deuxième partie conductrice (322) s'étend à partir d'une extrémité de la première partie conductrice (321). dans une direction orthogonale à la direction de longueur du dispositif électronique vers l'élément de surface latérale (410) à un niveau correspondant à la partie divisée (411c).

2. Dispositif électronique de la revendication 1, dans lequel la première partie conductrice (321) est prévue sur des côtés opposés de la partie divisée (411c) et la deuxième partie conductrice (322) est prévue sur des côtés opposés de la partie divisée (411c).

3. Dispositif électronique de l'une des revendications 1 à 2, dans lequel la partie conductrice (320) est formée en tant que motif conducteur.

4. Dispositif électronique de l'une des revendications 1 à 3, dans lequel la première partie conductrice (321) présente une largeur (w2) inférieure ou égale à la moitié d'une largeur (w1) de l'élément de protection.

5. Dispositif électronique de l'une des revendications 1 à 4, dans lequel la première partie conductrice a une largeur (w2) de 0,1 mm à 1,5 mm, de préférence de 0,3 mm à 1,2 mm, plus préférentiellement de 0,5 mm à 1 mm.

6. Dispositif électronique de l'une des revendications 1 à 5, dans lequel l'élément de surface latérale (410) comprend une première partie de surface latérale (411) s'étendant parallèlement à l'axe de pliage, une deuxième partie de surface latérale (412) s'étendant à partir d'une première extrémité de la première partie de surface latérale et perpendiculairement à l'axe de pliage, une troisième partie de surface latérale (413) s'étendant à partir d'une deuxième extrémité de la première partie de surface latérale et perpendiculairement à l'axe de pliage, et une quatrième partie de surface latérale (414) s'étendant entre la deuxième partie de surface latérale et la troisième partie de surface latérale et s'étendant parallèlement à l'axe de pliage, et
l'élément de protection (300) est disposé le long de l'élément de surface latérale (410), l'élément de surface latérale (410) définissant la première partie de surface latérale, la deuxième partie de surface latérale, la troisième partie de surface latérale et la quatrième partie de surface latérale.

7. Dispositif électronique de la revendication 6, dans lequel la partie conductrice (320) de l'élément de protection (300) est prévue à une position correspondant à la première partie de surface latérale (411) de l'élément de surface latérale (410).

8. Dispositif électronique selon la revendication 6, dans lequel la première partie conductrice (321) comprend une (1-1)^{ème} partie conductrice (321a) disposée à une position correspondant à une zone d'antenne de la première partie de surface latérale, et une (1-2)^{ème} partie conductrice (321b) disposée à une position correspondant à une zone non antenne de la première partie de surface latérale, et
la deuxième partie conductrice (322) comprend une (2-1)^{ème} partie conductrice (322a) s'étendant depuis une extrémité de la (1-1)^{ème} partie conductrice (321a) vers l'élément de surface latérale et une (2-2)^{ème} partie conductrice (322b) s'étendant depuis une extrémité de la (1-2)^{ème} partie conductrice (321b) vers l'élément de surface latérale.

9. Dispositif électronique selon la revendication 8, dans lequel la (2-2)^{ème} partie conductrice (322b) a une largeur (w4) supérieure à la largeur (w3) de la (2-1)^{ème} partie conductrice (322a).

10. Dispositif électronique de l'une des revendications 1 à 9, dans lequel la deuxième partie conductrice (322) s'étend vers l'élément de surface latérale (410) et est directement connectée à l'élément de surface latérale (410), ou s'étend vers l'élément de surface latérale (410) de sorte que l'électricité statique est induite vers l'élément de surface latérale (410).

11. Dispositif électronique de l'une des revendications 1 à 10, dans lequel la première partie conductrice (321) est disposée sur une surface intérieure de l'élément de protection (300) à une position faisant face à une surface avant de l'affichage flexible (200), et
la deuxième partie conductrice (322) s'étend à partir de la première partie conductrice (321) et est disposée sur la surface intérieure de l'élément de protection (300) à une position faisant face à une partie latérale de l'affichage flexible (200).

12. Dispositif électronique de l'une des revendications 1 à 11, comprenant en outre un élément non conducteur (500) disposé sur une surface intérieure de l'élément de protection (300) pour être espacé de l'affichage flexible (200) d'une distance spécifiée à une position chevauchant au moins partiellement la partie conductrice (320).

13. Dispositif électronique de l'une des revendications 1 à 12, dans lequel la partie conductrice (320) comprend une troisième partie conductrice (323) s'étendant vers l'élément de surface latérale (410) à partir de la première partie conductrice (321b) à une position qui ne correspond pas à la partie divisée (411c).

14. Dispositif électronique selon la revendication 13, dans lequel l'élément de surface latérale (410) comprend une zone anodisée qui a été au moins partiellement soumise à un traitement d'anodisation, et une position de l'élément de surface latérale (410) correspondant à la deuxième partie conductrice (322) ou à la troisième partie conductrice (323) comprend une zone non anodisée qui n'a pas été soumise à un traitement d'anodisation.
